(19) Europäisches Patentamt
European Patent Office
Office européen des brevets

(11) **EP 2 087 396 B1**

(12) **FASCICULE DE BREVET EUROPEEN**

(45) Date de publication et mention
de la délivrance du brevet:
**06.11.2013 Bulletin 2013/45**

(21) Numéro de dépôt: **07848285.8**

(22) Date de dépôt: **25.09.2007**

(51) Int Cl.:
***G02C 7/02*** *(2006.01)* ***G02C 7/06*** *(2006.01)*

(86) Numéro de dépôt international:
**PCT/FR2007/001562**

(87) Numéro de publication internationale:
**WO 2008/037892 (03.04.2008 Gazette 2008/14)**

(54) **PROCEDE DE DETERMINATION D'UNE LENTILLE OPHTALMIQUE**

VERFAHREN ZUR BESTIMMUNG EINES BRILLENGLASES

METHOD FOR DETERMINING AN OPHTHALMIC LENS

(84) Etats contractants désignés:
**AT BE BG CH CY CZ DE DK EE ES FI FR GB GR
HU IE IS IT LI LT LU LV MC MT NL PL PT RO SE
SI SK TR**

(30) Priorité: **28.09.2006 FR 0608515**

(43) Date de publication de la demande:
**12.08.2009 Bulletin 2009/33**

(73) Titulaire: **Essilor International
(Compagnie Générale d'Optique)
94220 Charenton-le-Pont (FR)**

(72) Inventeurs:
• **DE GAUDEMARIS, Diane
94227 Charenton Cedex (FR)**
• **GUILLOUX, Cyril
94227 Charenton Cedex (FR)**
• **MURADORE, Fabien
94227 Charenton Cedex (FR)**

(74) Mandataire: **Hirsch & Associés
58, avenue Marceau
75008 Paris (FR)**

(56) Documents cités:
**EP-A- 0 990 939    EP-A1- 0 055 878
DE-U1- 8 222 426    FR-A1- 2 509 482**

**Description**

La présente invention a pour objet un procédé de détermination d'une lentille ophtalmique et une lentille ophtalmique obtenue par un tel procédé.

Toute lentille ophtalmique, destinée à être portée dans une monture, est associée à une prescription. La prescription en matière ophtalmique peut comprendre une prescription de puissance, positive ou négative, ainsi qu'une prescription d'astigmatisme. Ces prescriptions correspondent à des corrections à apporter au porteur des lentilles pour corriger les défauts de sa vision. Une lentille est montée dans la monture en fonction de la prescription et de la position des yeux du porteur par rapport à la monture.

Dans les cas les plus simples, la prescription se réduit à une prescription de puissance, positive ou négative. La lentille est dite unifocale et présente une symétrie de révolution. Elle est simplement montée dans la monture de sorte que la direction principale du regard du porteur coïncide avec l'axe de symétrie de la lentille.

Pour les porteurs presbytes, la valeur de la correction de puissance est différente en vision de loin et en vision de près, du fait des difficultés d'accommodation en vision de près. La prescription est alors composée d'une valeur de puissance en vision de loin et d'une addition (ou progression de puissance) représentative de l'incrément de puissance entre la vision de loin et la vision de près; ceci revient à une prescription de puissance en vision de loin et à une prescription de puissance en vision de près. Les lentilles adaptées aux porteurs presbytes sont des lentilles multifocales progressives; ces lentilles sont décrites par exemple dans FR-A-2 699 294, US-A-5 270 745 ou US-A-5 272 495, FR-A-2 683 642, FR-A-2 699 294 ou encore FR-A-2 704 327. Les lentilles ophtalmiques multifocales progressives comprennent une zone de vision de loin, une zone de vision de près, une zone de vision intermédiaire, une méridienne principale de progression traversant ces trois zones. Elles sont généralement déterminées par optimisation, à partir d'un certain nombre de contraintes imposées aux différentes caractéristiques de la lentille. Ces lentilles sont généralistes, en ce qu'elles sont adaptées aux différents besoins courants du porteur. On définit des familles de lentilles multifocales progressives, chaque lentille d'une famille étant caractérisée par une addition, qui correspond à la variation de puissance entre la zone de vision de loin et la zone de vision de près. Plus précisément, l'addition, notée A, correspond à la variation de puissance sur la méridienne entre un point VL de la zone de vision de loin et un point VP de la zone de vision de près, qui sont appelés respectivement point de référence de la vision de loin et point de référence de la vision de près, et qui représentent les points d'intersection du regard et de la surface de la lentille pour une vision à l'infini et pour une vision de lecture.

De manière classique, une lentille peut être définie par sa base (ou sphère moyenne en vision de loin) et par une addition de puissance dans le cas d'une lentille multifocale. A partir de lentilles semi-finies, dont seule une face est conformée avec un couple addition/base donné, il est possible de préparer des lentilles adaptées à chaque porteur, par simple usinage d'une face de prescription qui est généralement sphérique ou torique.

Pour toute lentille ophtalmique, les lois de l'optique des tracés de rayons entraînent l'apparition de défauts optiques quand les rayons lumineux s'écartent de l'axe central de toute lentille. Ces défauts connus qui comprennent entre autres un défaut de courbure ou de puissance et un défaut d'astigmatisme peuvent être appelés de façon générique défauts d'oblicité des rayons. L'homme de l'art sait compenser ces défauts. Par exemple, EP-A-0 990 939 propose un procédé de détermination par optimisation d'une lentille ophtalmique pour un porteur ayant une prescription d'astigmatisme. Les défauts d'oblicité ont aussi été identifiés pour les lentilles multifocales progressives. Par exemple, WO-A-98 12590 décrit une méthode de détermination par optimisation d'un jeu de lentilles ophtalmiques multifocales

Une lentille ophtalmique comporte une zone centrale optiquement utile qui peut s'étendre sur la totalité de la lentille. On entend par zone optiquement utile, une zone dans laquelle les défauts de courbure et d'astigmatisme ont été minimisés pour permettre un confort visuel satisfaisant pour le porteur. Sur une lentille progressive, la zone centrale optiquement utile couvrira la zone de vision de loin, la zone de vision de près et la zone de progression.

Généralement, la zone optiquement utile couvre la totalité de la lentille qui présente un diamètre de valeur limitée. Cependant, dans certains cas, une zone périphérique est prévue sur les pourtours de la lentille ophtalmique. Cette zone est dite périphérique car elle ne répond pas aux conditions de correction optique prescrite et présente des défauts d'oblicités importants. Les défauts optiques de la zone périphérique ne nuisent pas au confort visuel du porteur car cette zone se situe en dehors du champ de vision du porteur. Un raccord doit alors être prévu entre la zone centrale optiquement utile et la zone périphérique.

Il existe principalement deux situations dans lesquelles une lentille ophtalmique présentera une telle zone périphérique. D'une part, lorsque la lentille présente un diamètre important qui peut être imposé par la forme de la monture, par exemple une monture allongée avec un fort galbe, et d'autre part lorsque la prescription de puissance est élevée, la lentille présentant alors une épaisseur bord ou centre importante que l'on cherche à réduire.

Dans le cas d'une lentille ophtalmique destinée à être adaptée dans une monture galbée, par exemple à 15°, le verre présente une face sphérique ou torique de forte cambrure (ou base), entre 6 dioptries et 10 dioptries, et une face calculée spécifiquement pour atteindre la correction optimale de l'amétropie du porteur au centre optique et dans le champ de vision. Par exemple, pour une même face avant, ayant une même courbure, la face arrière est usinée pour assurer la correction en fonction de l'amétropie de chaque porteur. La forte cambrure de la face avant entraîne une forte épaisseur du verre sur les bords dans le cas d'une lentille négative ou une forte épaisseur du verre au centre dans le cas d'une lentille positive. Ces fortes épaisseurs alourdissent le poids des lentilles, ce qui nuit au confort du porteur et les rendent inesthétiques. De plus, pour certaines montures, l'épaisseur bord doit être limitée pour permettre le montage du verre dans la monture.

Pour des lentilles négatives, les épaisseurs bords peuvent être réduites par rabotage grâce à une facette manuelle. Un amincissement de la lentille peut aussi être contrôlé par optimisation optique. Une asphérisation ou une atorisation peuvent être calculées, au moins pour une des faces de la lentille, en prenant en compte les conditions de port de la lentille par rapport à une lentille de faible cambrure de même prescription, afin de diminuer les épaisseurs centre et bord de la lentille de forte cambrure. De telles solutions d'asphérisation ou d'atorisation optiques sont par exemple décrites dans les documents US-A-6 698 884, US-A-6 454 408, US-A-6 334 681, US-A-6 364 481 ou encore WO-A-97 35224.

Par ailleurs, dans le cas d'une lentille de forte prescription, le verre détouré présente une épaisseur bord importante, côté nasal pour un verre positif hypermétrope et côté temporal pour un verre négatif myope. Ces surépaisseurs bords compliquent le montage de la lentille dans la monture et alourdissent le port des lentilles ophtalmiques.

FR-A-2 638 246 propose une lentille ophtalmique de forte puissance positive et d'épaisseur au centre réduite. La lentille décrite dans ce document présente une zone de raccord entre une zone centrale optiquement utile et une zone périphérique. Cette zone de raccord est située sur la face avant de forte cambrure et présente une symétrie de révolution ; le raccord est obtenu directement par moulage de la face avant.

EP-A-0 371 460 propose une lentille ophtalmique de forte puissance avec une face avant à symétrie de révolution ayant un rayon de courbure qui augmente sur la périphérie de la lentille afin de réduire les épaisseurs bords.

US-A-6 176 577 propose une lentille ophtalmique pour hypermétrope présentant une face à symétrie de révolution ayant une zone centrale optiquement utile et une zone périphérique d'épaisseur réduite. Le raccord entre la zone centrale et la zone périphérique est obtenu directement par moulage.

Les solutions de l'art antérieur proposent de réduire l'épaisseur bord et/ou centre des verres de lentilles ophtalmiques à symétrie de révolution en asphérisant ou en atorisant une face de la lentille, généralement la face de prescription. Les solutions proposées dans l'art antérieur ne sont pas applicables à tout type de verre et en particulier ne peuvent être appliquées dans le cas de lentilles ophtalmiques multifocales. De fait, les solutions proposées dans l'art antérieur présentent un raccord à symétrie de révolution entre la zone centrale optiquement utile et la zone périphérique amincie.

De plus, il existe toujours un besoin d'une lentille qui satisfasse mieux les porteurs avec des performances optiques optimales tout en présentant une épaisseur réduite pour améliorer l'aspect esthétique du verre et le confort du porteur.

A cet effet, l'invention propose une lentille ophtalmique avec une première face (par exemple la face avant) avec un rayon de courbure maximal donné et une deuxième face (par exemple la face arrière) complexe présentant une zone centrale optiquement utile assurant la correction prescrite au porteur, une zone périphérique et une zone de raccord entre les zones centrale et périphérique. Le rayon de courbure maximal de la zone périphérique est compris entre le rayon de courbure maximal de la première face et le rayon de courbure maximal de la zone centrale de la deuxième face ; il est choisi pour optimiser l'amincissement de la lentille. Une fonction d'interpolation est choisie et appliquée aux zones centrale et périphérique de cette deuxième face pour définir une zone de raccord entre la zone centrale et la zone périphérique. La surface interpolée est calculée dans les conditions du porté pour minimiser une fonction de mérite en fonction de l'altitude relative de la zone périphérique par rapport à la zone centrale. L'invention permet ainsi d'obtenir une lentille présentant une épaisseur réduite, de par la contrainte imposée sur la zone périphérique, et un confort amélioré pour le porteur par une optimisation du positionnement spatial relatif des zones centrale et périphérique de la surface interpolée de la deuxième face. La deuxième face peut être usinée en une seule fois par une technique d'usinage directe.

L'invention propose en conséquence un procédé de détermination d'une lentille ophtalmique comprenant les étapes de :

- choix d'une lentille de départ avec une première face et une deuxième face ;
- définition d'une surface de départ pour la deuxième face de la lentille avec une zone centrale de diamètre $D_{ini}$ et une zone périphérique de diamètre intérieur $D_{rac}$ supérieur au diamètre $D_{ini}$ de la zone centrale, chaque point de la zone centrale et de la zone périphérique présentant une altitude définie par rapport à un axe normal à la deuxième face de la lentille et ayant pour origine le centre de la zone centrale, l'altitude de la zone périphérique étant définie comme l'altitude du point le plus bas situé sur le diamètre intérieur $D_{rac}$ ;

la zone périphérique ayant un rayon de courbure maximal compris entre le rayon de courbure maximal de la première face et le rayon de courbure maximal de la zone centrale ;

- choix d'une formule d'interpolation ;
- définition d'une lentille courante égale à la lentille de départ ;
- optimisation de la lentille courante en appliquant

- des valeurs cibles de puissance et d'astigmatisme pour des directions de regard données dans la zone centrale de la deuxième face de la lentille ;
- la formule d'interpolation aux zones centrale et périphérique pour définir une surface interpolée comprenant une zone de raccord, la surface interpolée minimisant une fonction de mérite pour différentes altitudes relatives de la zone périphérique par rapport à la zone centrale.

Selon les modes de réalisation, le procédé de détermination d'une lentille ophtalmique selon l'invention peut comprendre une ou plusieurs des caractéristiques suivantes :

- l'optimisation de la zone centrale de la lentille courante est réalisée dans les conditions du porté ;
- la fonction de mérite est une minimisation des écarts quadratiques moyens en sphères et en cylindres calculés sur un ensemble de points entre la surface interpolée et les surfaces initiales des zones centrale et périphérique ;
- l'ensemble de points pour lesquels une minimisation des écarts quadratiques moyens en sphères et en cylindres sont calculés consiste dans les axes verticaux et horizontaux de la lentille ;
- l'ensemble de points pour lesquels une minimisation des écarts quadratiques moyens en sphères et en cylindres sont calculés consiste dans les cercles de diamètre $D_{ini}$ et $D_{rac}$ délimitant respectivement les zones centrale et périphérique ;
- la fonction de mérite est une minimisation de la valeur du cylindre maximal dans la zone de raccord ;
- la fonction de mérite est une minimisation de la norme du gradient de sphère ou de cylindre dans la zone de raccord ;
- les zones centrale, de raccord et périphérique sont centrées sur un même point de la surface de la deuxième face de la lentille, ledit point de centrage matérialisant la direction primaire du regard dans les conditions du porté ;
- la première face de la lentille est choisie complexe ;
- la première face et la zone périphérique de la deuxième face de la lentille sont choisies sphériques ;
- la première face et la zone périphérique de la deuxième face de la lentille sont choisies toriques ;
- la zone centrale de la deuxième face est choisie avec une variation de puissance ;
- la zone centrale et la zone périphérique de la deuxième face sont choisies avec une variation de puissance ;
- le diamètre de la zone centrale est choisi supérieur ou égal à 30 mm et inférieur d'au moins 10 mm au diamètre total de la lentille avant détourage ;
- le diamètre intérieur de la zone périphérique est choisi supérieur ou égal d'au moins 10 mm au diamètre de la zone centrale et inférieur au diamètre total de la lentille avant détourage.

Selon un mode de réalisation, la fonction de mérite de la minimisation des écarts quadratiques moyens en sphères et en cylindres verticaux et horizontaux entre la surface interpolée et les surfaces des zones centrale et périphérique est définie comme : FM = a FM_X + b FM_Y ;

Avec a et b des coefficients de pondération ; et avec

$$FM\_X = \sqrt{\frac{\sum_{i=1}^{n}(Sph\_xi - Sph'\_xi)^2}{n}} + \sqrt{\frac{\sum_{i=1}^{n}(Cyl\_xi - Cyl'\_xi)^2}{n}}$$

$$FM\_Y = \sqrt{\frac{\sum_{i=1}^{n}(Sph\_yi - Sph'\_yi)^2}{n}} + \sqrt{\frac{\sum_{i=1}^{n}(Cyl\_yi - Cyl'\_yi)^2}{n}}$$

Où *Sph_xi* et *Shp_yi* sont les valeurs de sphères initiales en un point considéré dans la zone centrale ou dans la zone périphérique sur l'axe X et sur l'axe Y ;
Où *Cyl_xi* et *Cyl_yi* sont les valeurs de cylindres initiales en un point considéré dans la zone centrale ou dans la zone périphérique sur l'axe X et sur l'axe Y ; et

Où *Sph'_xi, Shp_yi* et *Cyl'_xi, Cyl'_yi* sont les valeurs de sphères et de cylindres en un point considéré de la surface interpolée dans la zone de raccord sur l'axe X et sur l'axe Y.

D'autres avantages et caractéristiques de l'invention apparaîtront à la lecture de la description qui suit des modes de réalisation de l'invention, donnés à titre d'exemple et en référence aux dessins qui montrent:

- figure 1, une vue schématique de la face arrière d'une lentille selon l'invention;
- figure 2, une vue schématique de la modélisation de la zone centrale et de la zone périphérique de la lentille selon l'invention ;
- figures 3 et 4, des graphes de puissance optique porteur le long de la méridienne respectivement d'une lentille cambrée et galbée unifocale classique et d'une lentille cambrée et galbée unifocale selon l'invention ;
- figure 5 et 6, des cartes de puissance optique porteur des lentilles des figures 3 et 4 respectives ;
- figures 7 et 8, des cartes de module d'astigmatisme résultant d'un porteur des lentilles des figures 3 et 4 respectives;
- figures 9 et 10, des vues schématiques en coupe des lentilles des figures 3 et 4 respectives;
- figures 11 et 12, des graphes de puissance optique porteur le long de la méridienne respectivement d'une lentille multifocale progressive de prescription positive, cambrée et galbée classique et d'une lentille multifocale progressive de prescription positive, cambrée et galbée selon l'invention ;
- figure 13 et 14, des cartes de puissance optique porteur des lentilles des figures 11 et 12 respectives ;
- figures 15 et 16, des cartes de module d'astigmatisme résultant d'un porteur des lentilles des figures 11 et 12 respectives;
- figures 17 et 18, des vues schématiques en coupe des lentilles des figures 11 et 12 respectives;
- figures 19 et 20, des graphes de puissance optique porteur le long de la méridienne respectivement d'une lentille multifocale progressive de prescription négative, cambrée et galbée classique et d'une lentille multifocale progressive de prescription négative, cambrée et galbée selon l'invention ;
- figure 21 et 22, des cartes de puissance optique porteur des lentilles des figures 19 et 20 respectives ;
- figures 23 et 24, des cartes de module d'astigmatisme résultant d'un porteur des lentilles des figures 19 et 20 respectives;
- figures 25 et 26, des vues schématiques en coupe des lentilles des figures 19 et 20 respectives;
- figures 27 et 28, des graphes de puissance optique porteur le long de la méridienne respectivement d'une lentille multifocale progressive classique de forte prescription négative et d'une lentille multifocale progressive de forte prescription négative selon l'invention ;
- figure 29 et 30, des cartes de puissance optique porteur des lentilles des figures 27 et 28 respectives ;
- figures 31 et 32, des cartes de module d'astigmatisme résultant d'un porteur des lentilles des figures 27 et 28 respectives;
- figures 33 et 34, des vues schématiques en coupe des lentilles des figures 27 et 28 respectives;
- figures 35 et 36, des graphes de puissance optique porteur le long de la méridienne respectivement d'une lentille multifocale progressive classique de forte prescription positive et d'une lentille multifocale progressive de forte prescription positive selon l'invention ;
- figure 37 et 38, des cartes de puissance optique porteur des lentilles des figures 35 et 36 respectives ;
- figures 39 et 40, des cartes de module d'astigmatisme résultant d'un porteur des lentilles des figures 35 et 36 respectives;
- figures 41 et 42, des vues schématiques en coupe des lentilles des figures 35 et 36 respectives;
- figure 43, un schéma d'un système optique oeil-lentille, en coupe verticale ;
- figures 44 et 45, des schémas en perspective d'un système oeil-lentille.

De façon connue en soi, en tout point d'une surface, on définit une sphère moyenne D donnée par la formule:

$$D = \frac{n-1}{2}\left(\frac{1}{R_1} + \frac{1}{R_2}\right)$$

où $R_1$ et $R_2$ sont les rayons de courbure maximal et minimal exprimés en mètres, et n l'indice du matériau constituant la lentille.

On définit aussi un cylindre C, donné par la formule:

$$C = (n-1)\left|\frac{1}{R_1} - \frac{1}{R_2}\right|$$

Les caractéristiques de la face complexe de la lentille peuvent être exprimées à l'aide de la sphère moyenne et du cylindre. On peut aussi définir une lentille donnée par des caractéristiques optiques, à savoir une puissance et un astigmatisme, dans les conditions du porté.

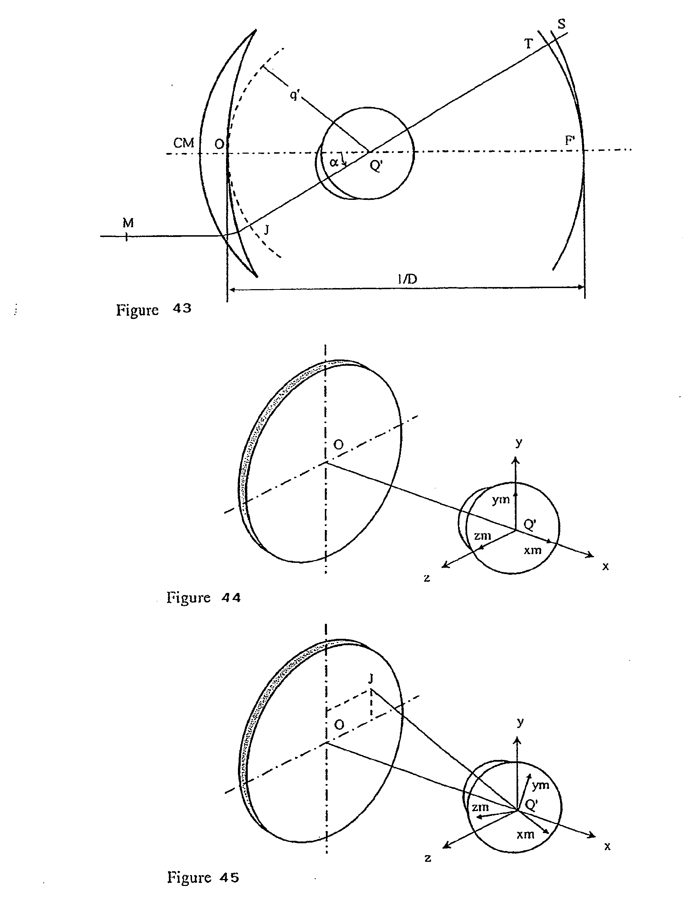

On définit pour une lentille donnée, les grandeurs optiques correspondantes, à savoir une puissance et un astigmatisme, dans les conditions du porté. La figure 43 montre un schéma d'un système optique oeil et lentille en vue de dessus, et montre les définitions utilisées dans la suite de la description. On appelle Q' le centre de rotation de l'oeil; l'axe Q'F' représenté sur la figure en traits mixtes est l'axe horizontal passant par le centre de rotation de l'oeil et s'étendant devant le porteur - autrement dit l'axe Q'F' correspond à la direction primaire du regard. Cet axe coupe, sur la face avant, un point de la lentille appelé Croix de Montage, qui est matérialisé sur les lentilles pour permettre leur positionnement par un opticien ; cette croix de montage CM permet de repérer sur la lentille la direction primaire du regard dans les conditions du porté. Soit le point O, point d'intersection de la face arrière et de cet axe Q'F'. On définit une sphère des sommets, de centre Q', et de rayon q', qui coupe la face arrière de la lentille au point O. A titre d'exemple, une valeur du rayon q' de 27 mm correspond à une valeur courante et fournit des résultats satisfaisants lors du porté des lentilles. On peut dessiner la coupe de la lentille dans le plan (O, x, y) défini en référence à la figure 44. La tangente à cette courbe au point O est inclinée par rapport à l'axe (O, y) d'un angle appelé angle pantoscopique. On peut également dessiner la coupe de la lentille dans le plan (O, x, z). La tangente à cette courbe au point O est inclinée par rapport à l'axe (O, z) d'un angle appelé galbe.

Une direction donnée du regard - représentée en traits pleins sur la figure 43 - correspond à une position de l'oeil en rotation autour de Q' et à un point J de la sphère des sommets; une direction du regard peut aussi être repérée, en coordonnées sphériques, par deux angles $\alpha$ et $\beta$. L'angle $\alpha$ est l'angle formé entre l'axe Q'F' et la projection de la droite Q'J sur le plan vertical contenant l'axe Q'F; cet angle apparaît sur le schéma de la figure 43. L'angle $\beta$ est l'angle formé entre l'axe Q'F' et la projection de la droite Q'J sur le plan horizontal contenant l'axe Q'F'. Une direction donnée du regard correspond donc à un point J de la sphère des sommets ou à un couple ($\alpha$, $\beta$).

Dans une direction donnée du regard, l'image d'un point M de l'espace objet situé à une distance objet donnée, se forme entre deux points S et T correspondant à des distances JS et JT minimale et maximale (qui seraient des distances focales sagittales et tangentielles dans le cas de surfaces de révolution, et d'un point M à l'infini).

A l'aide de ces éléments, on peut définir une puissance et un astigmatisme, dans chaque direction du regard. Pour une direction du regard ($\alpha$, $\beta$), on considère un point M objet à une distance objet donnée par l'ergorama. On détermine les points S et T entre lesquels se forme l'image de l'objet. La proximité image PI est alors donnée par

$$PI = \frac{1}{2}\left(\frac{1}{JT} + \frac{1}{JS}\right)$$

tandis que la proximité obj et PO est l'inverse de la distance entre le point M et le point J de la sphère des sommets. La puissance est définie comme la somme des proximité objet et image, soit

$$P = PO + PI = \frac{1}{MJ} + \frac{1}{2}\left(\frac{1}{JT} + \frac{1}{JS}\right)$$

L'amplitude de l'astigmatisme est donnée par

$$A = \left|\frac{1}{JT} - \frac{1}{JS}\right|$$

La puissance et l'astigmatisme peuvent être mesurées expérimentalement sur la lentille en utilisant un frontofocomètre; elles peuvent aussi être calculées par tracé de rayons dans les conditions du porté.

L'invention propose une lentille ophtalmique qui présente des épaisseurs centre et bord diminuées par rapport à une lentille classique de même prescription ayant une cambrure identique. L'amincissement de la lentille selon l'invention est calculé dans les conditions du porté par un procédé d'optimisation d'une zone de raccord entre une zone centrale optiquement utile de la lentille et une zone périphérique. La lentille ainsi obtenue est plus légère et plus esthétique tout en conservant les caractéristiques optiques dans le champ de vision du porteur d'une lentille non amincie pour une même prescription.

La lentille de l'invention présente une première face qui peut être sphérique, torique ou complexe. L'autre face de la lentille selon l'invention est complexe ; elle est calculée pour adapter la lentille à l'amétropie de l'utilisateur et pour optimiser la lentille dans les conditions du porté en imposant un amincissement des épaisseurs centre et bord du verre de la lentille. Dans le cas d'une lentille multifocale progressive, on préférera réaliser une seule surface complexe sur une des faces de la lentille pour réaliser la variation de puissance et la zone de raccord par usinage direct d'une seule face. Il est néanmoins possible de réaliser une surface complexe sur chacune des faces de la lentille.

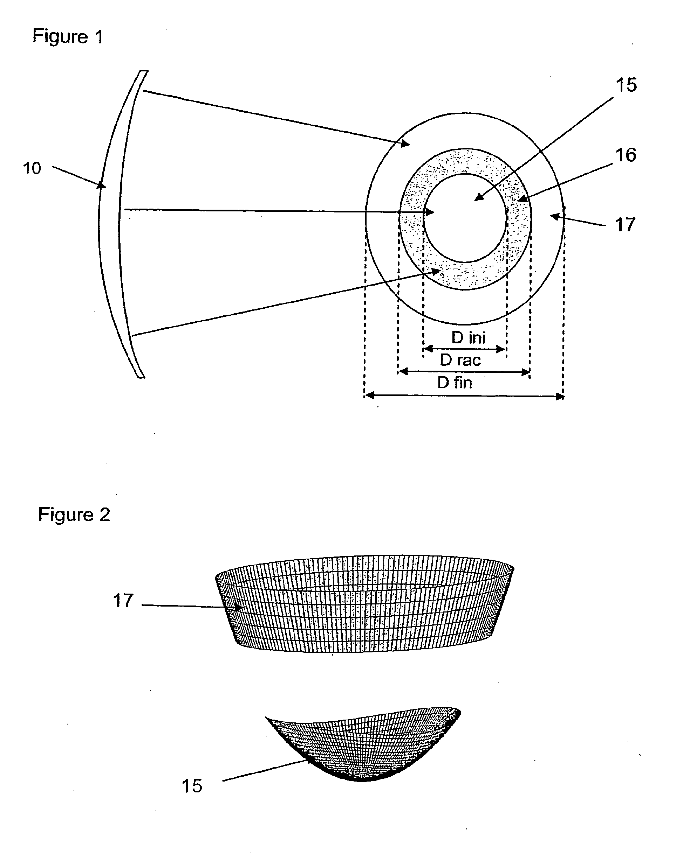

Dans la description des figures 1 et 2, on considérera une face avant, opposée au porteur de lunettes, sphérique ou torique présentant un rayon de courbure maximal, et une face arrière complexe présentant trois zones qui vont être décrites en détails plus bas. Il est entendu que le rôle des faces avant et arrière peut être inversé ou que la surface complexe peut être répartie sur les deux faces de la lentille.

La figure 1 montre un schéma d'une lentille 10 selon l'invention. La face arrière est composée de trois zones ; une zone centrale 15 optiquement utile assurant la correction nécessaire au porteur dans son champ de vision ; une zone périphérique 17 ayant un rayon de courbure différent de la zone centrale pour assurer l'amincissement du bord de la lentille; et une zone de raccord 16 reliant les zones centrale et périphérique. La zone centrale 15 peut comporter une correction de puissance et/ou d'astigmatisme et/ou elle peut être dégressive. La surface de cette face arrière complexe est continue d'un point de vue mathématique et s'usine en une seule fois par usinage direct. La zone de raccord 16 permet cette continuité mathématique et assure que les caractéristiques optiques de la zone centrale 15 ne sont pas modifiées par les contraintes mécaniques imposées à la zone périphérique.

Les trois zones 15, 16 et 17 de la face arrière sont centrées sur le même point, de préférence sur la croix de montage qui correspond à la direction primaire du regard du porteur dans les conditions du porté. Les trois zones 15, 16 et 17 de la face arrière de la lentille sont de forme identique, cette forme (circulaire, elliptique, ou autre) étant choisie en fonction de la monture et/ou de la prescription. Les dimensions de chaque zone sont variables et dépendent de la monture et de la prescription. La zone centrale 15 doit avoir une dimension suffisament grande pour assurer un large champ optique au porteur et la zone de raccordement 16 doit avoir une largeur suffisamment grande pour limiter la visibilité de la transition et suffisament petite pour que la zone périphérique 17 soit assez large pour permettre un amincissement suffisant de l'épaisseur de la lentille. Dans ce contexte, on considère le diamètre $D_{ini}$ de la zone centrale 15 initiale avant raccord et le diamètre extérieur $D_{fin}$ de la zone périphérique 17 qui correspond au diamètre total de la lentille avant détourage. La zone de raccord 16 s'étend alors entre un diamètre intérieur égal au diamètre de la zone centrale $D_{ini}$ et un diamètre extérieur noté $D_{rac}$ qui correspond au diamètre intérieur de la zone périphérique 17.

On peut considérer que la zone centrale 15 sera suffisamment grande pour assurer un large champ de correction optique au porteur si le diamètre de la zone centrale de la lentille $D_{ini}$ avant détourage est supérieur à 30 mm et inférieur à $D_{fin}$ d'au moins 10 mm ($30 \leq D_{ini} \leq D_{fin} - 10$). De même, on peut considérer que l'étendue de la zone de raccord est optimale lorsqu'elle est supérieure au diamètre de la zone centrale d'au moins 10 mm. En outre, le diamètre extérieur de la zone de raccord doit rester inférieur à $D_{fin}$ pour garantir la présence d'une zone périphérique ($D_{ini} + 10 \leq D_{rac} < D_{fin}$).

Les surfaces constituant les zones centrale 15 et périphérique 17 sont connues car imposées par les contraintes de monturisation et/ou de prescription. Ces surfaces des zones centrale 15 et périphérique 17 sont alors échantillonnées comme illustré sur la figure 2. On connaît en effet leurs coordonnées dans un repère (X, Y, Z) lié à la face arrière de la lentille. Par convention, l'axe X s'étend horizontalement et l'axe Y s'étend verticalement lorsque l'on considère la lentille dans les conditions du porté. L'axe Z est normal à la face arrière de la lentille. Sur les zones centrale 15 et périphérique 17, on connaît l'altidude Z en chaque point (X, Y) de la surface. Par convention, on peut fixer l'origine de l'axe Z au centre de la zone centrale 15. Dans ce contexte, on peut définir l'altitude de la zone périphérique comme la valeur en Z du point le plus bas de cette zone, soit le miminum en Z des points situés sur le cercle de diamètre $D_{rac}$ délimitant la zone périphérique 17 vers l'intérieur de la lentille.

Une formule d'interpolation calcule alors les altitudes Z des points situés dans la zone de raccord 16 pour définir une surface interpolée qui minimise une fonction de mérite évaluée pour différentes altitudes relatives de la zone périphérique par rapport à la zone centrale. La zone périphérique est donc déplacée en Z jusqu'à obtenir la surface interpolée qui donne la plus petite fonction de mérite. Le déplacement en Z de la zone périphérique ne modifie pas les caractéristiques de courbures initiales de la zone centrale de la surface interpolée. La surface interpolée de la face arrière peut être calculée, par exemple, par une méthode d'interpolation globale par spline, comme implémentée dans une fonction Matlab (d'après : de Boor, C., A Practical Guide to Splines, Springer-Verlag, 1978) ou par une méthode d'interpolation locale par polynômes.

La zone périphérique 17 peut être une surface sphérique ou torique, selon la géométrie de la face avant, ou une surface complexe. Dans le cas d'une surface périphérique sphérique, le rayon de courbure de la zone périphérique peut être égal à la base de la face avant ; le verre est alors plan dans la zone périphérique. Dans le cas d'une surface périphérique torique, le méridien de plus grande cambrure peut être choisi égal à la base de la face avant ; la valeur de la cambrure du second méridien ainsi que l'axe sont choisis en fonction de la prescription du verre. La zone périphérique 17 peut aussi être une surface complexe présentant une variation de puissance. En particulier, dans le cas d'une zone centrale présentant une variation de puissance, la zone périphérique peut être de même nature, c'est-à-dire progressive ou dégressive, avec un rayon de courbure maximal compris entre le rayon de courbure maximal de la face avant et le rayon de courbure maximal de la zone centrale.

La face arrière n'est ensuite calculée que lorsqu'on connaît les paramètres du porteur (prescription) et de la monture (galbe, dimension). La zone centrale 15 est asphérisée ou atorisée grâce à une optimisation optique. Cette asphérisation / atorisation peut prendre en compte les conditions de port comme l'angle de galbe et l'angle pantoscopique de la monture. De plus le calcul tient compte d'une prescription prismatique permettant de corriger les effets du galbe et/ou de l'angle pantoscopique. La zone centrale est optimisée pour que la lentille, dans les conditions du porté, présente les mêmes déviations prismatiques à la croix de montage que pour une lentille de même prescription montée dans une monture de galbe nul.

La zone de raccord 16 est calculée par la formule d'interpolation choisie pour minimiser une fonction de mérite en fonction du positionnement relatif en Z de la zone périphérique avec la zone centrale. La fonction de mérite choisie peut être une minimisation des écarts quadratiques moyens en sphères et en cylindres calculés sur un ensemble de points, par exemple sur les axes horizontaux et verticaux de la lentille ou sur les cercles de diamètre $D_{ini}$ et $D_{rac}$, entre la surface interpolée et les surfaces initiales des zones centrale et périphérique. La fonction de mérite choisie peut également être une minimisation de la valeur du cylindre dans la zone de raccord 16 ou une minimisation des pentes (norme du gradient) de sphère ou de cylindre dans la zone de raccord 16.

Dans les exemples qui suivent, la formule d'interpolation utilisée est une méthode d'interpolation globale par spline et la fonction de mérite choisie est la somme de écarts quadratiques moyens des sphères et cylindres dans les deux directions du plan de la lentille (X, Y), soit une minimisation des écarts quadratiques moyens en sphères et en cylindres verticaux et horizontaux entre la surface interpolée et les surfaces initiales des zones centrale et périphérique.

Pour les exemples décrits ci-dessous et illustrés dans les figures annexées, la fonction de mérite utilisée dans le programme d'interpolation de la surface complexe comprenant la zone de raccord 16 peut s'exprimer comme suit :

$$FM = a\,FM\_X + b\,FM\_Y\;;$$

Avec a et b des coefficients de pondération ; et

$$FM\_X = \sqrt{\frac{\sum_{i=1}^{n}\left(Sph\_xi - Sph'\_xi\right)^2}{n}} + \sqrt{\frac{\sum_{i=1}^{n}\left(Cyl\_xi - Cyl'\_xi\right)^2}{n}}$$

$$FM\_Y = \sqrt{\frac{\sum_{i=1}^{n}\left(Sph\_yi - Sph'\_yi\right)^2}{n}} + \sqrt{\frac{\sum_{i=1}^{n}\left(Cyl\_yi - Cyl'\_yi\right)^2}{n}}$$

Où $Sph\_xi$ et $Shp\_yi$ sont les valeurs de sphères initiales en un point considéré dans la zone centrale ou dans la zone périphérique sur l'axe X et sur l'axe Y

Où $Cyl\_xi$ et $Cyl\_yi$ sont les valeurs de cylindres initiales en un point considéré dans la zone centrale ou dans la zone périphérique sur l'axe X et sur l'axe Y

Où $Sph'\_xi, Shp'\_yi$ et $Cyl'\_xi, Cyl'\_yi$ sont les valeurs de sphères et de cylindres en un point considéré de la surface interpolée dans la zone de raccord sur l'axe X et sur l'axe Y.

Dans les exemples de figures annexées, le diamètre initial $D_{ini}$ utilisé vaut 44 mm, le diamètre de raccord $D_{rac}$ vaut 64 mm et le diamètre final $D_{fin}$ vaut 80 mm.

**EP 2 087 396 B1**

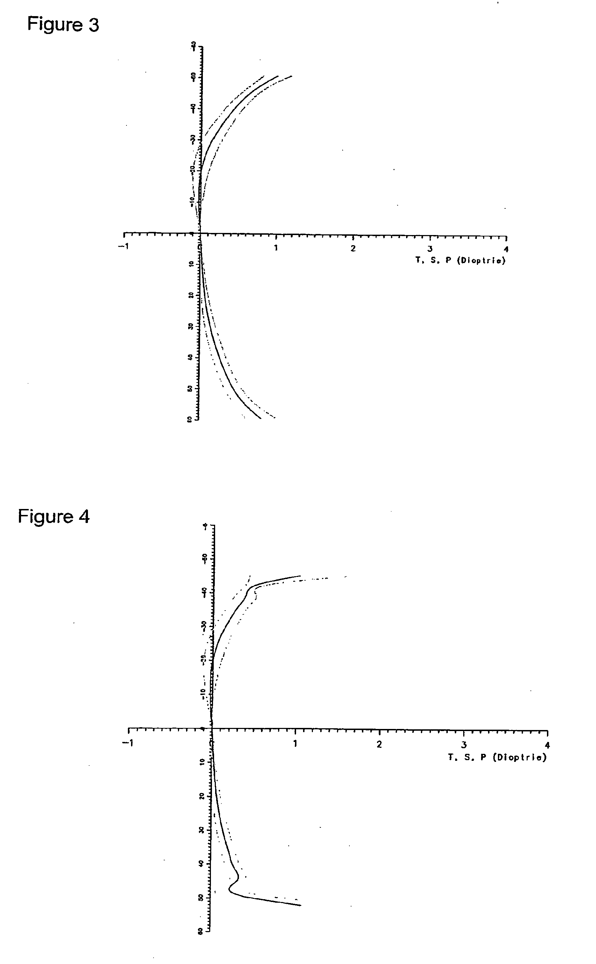

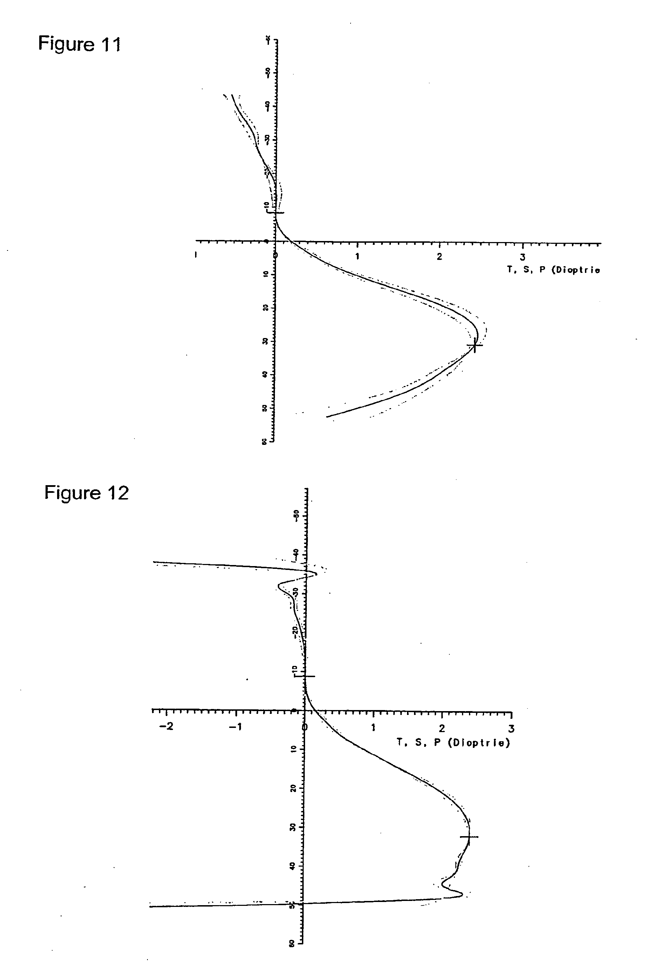

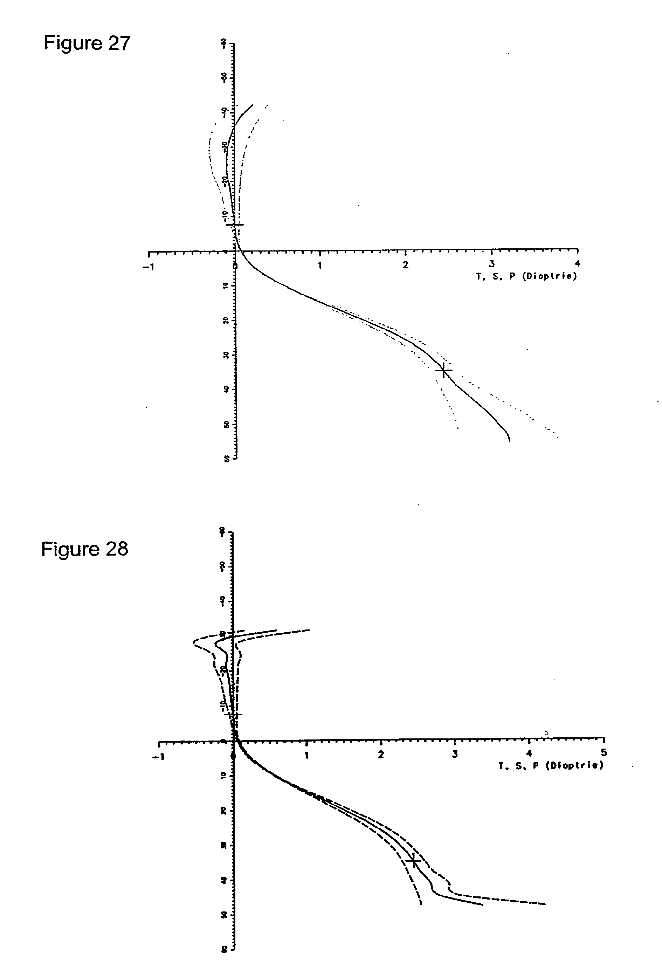

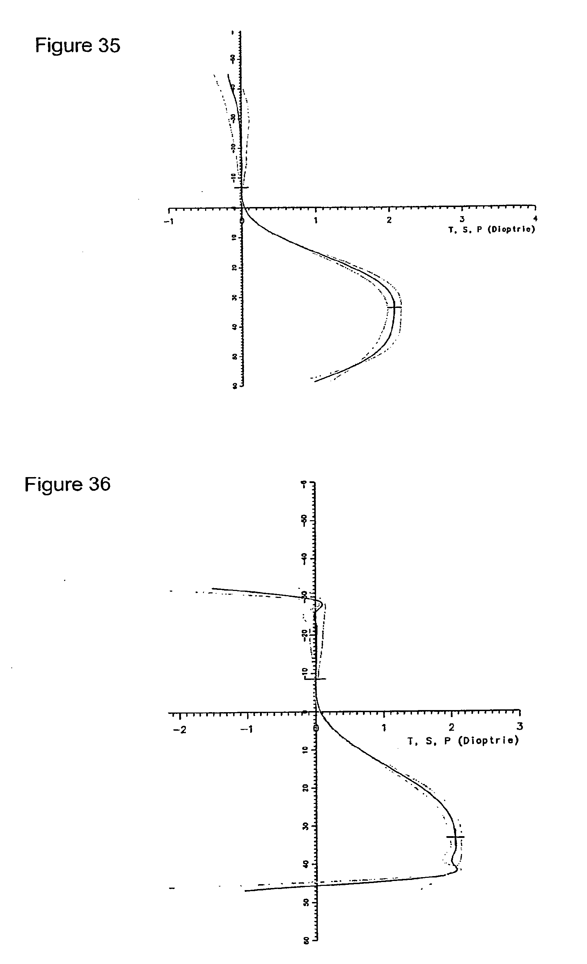

La lentille est décrite dans la suite en référence à plusieurs modes de réalisation. Selon un premier mode de réalisation, la lentille présente une cambrure importante pour être montée dans une monture de forme allongée galbée. Une telle lentille peut être unifocale (figures 3 à 10) ou multifocale progressive (figures 11 à 26). Selon un autre mode de réalisation, la lentille présente une forte prescription négative (figures 27 à 34) ou positive (figures 35 à 42). Dans chaque exemple illustré, l'épaisseur de la lentille a été réduite selon le procédé d'optimisation de l'invention.

Selon un premier exemple de réalisation, les figures 3 à 10 montrent une lentille unifocale de prescription -4 dioptries avec une face avant sphérique de base 8. La lentille ne présente pas de prisme. Le plan du verre est incliné par rapport à la verticale de 8° et présente un galbe de 15° pour un diamètre de 78 mm. Le verre présente un indice de 1,665. On a considéré une valeur de q' de 27 mm (telle que définie en référence à la figure 43) pour les mesures sur la lentille des figure 3 à 8.

Les figures 3, 5, 7 et 9 se rapportent à une lentille classique ayant les caractéristiques indiquées ci-dessus avec une face arrière asphérisée. Les figures 4, 6, 8 et 10 se rapportent à une lentille selon l'invention ayant les caractéristiques indiquées ci-dessus avec une face arrière asphérisée et raccordée.

La lentille présente une ligne sensiblement ombilique, dite méridienne, sensiblement confondue avec l'axe vertical de la lentille. Les figures montrent la méridienne ainsi que la croix de montage CM de la lentille qui peut être repérée géométriquement sur la lentille par une croix ou toute autre marque telle qu'un point entouré d'un cercle tracé sur la lentille, ou par tout autre moyen approprié; il s'agit d'un point de centrage matérialisé sur la lentille qui est utilisé par l'opticien pour le montage de la lentille dans la monture. En coordonnées sphériques, la croix de montage CM présente les coordonnées (0, 0) puisqu'elle correspond au point d'intersection de la face avant de la lentille avec la direction primaire du regard, comme définie précédemment.

Les figures 3 et 4 montrent la puissance optique porteur le long de la méridienne respectivement pour la lentille cambrée et galbée unifocale classique et pour la lentille cambrée et galbée unifocale selon l'invention ; on a porté en ordonnées l'angle $\beta$ et en abscisses la puissance en dioptries. On a reporté en pointillés les puissances optiques minimale et maximale correspondant respectivement aux quantités 1/JT et 1/JS définies précédemment, et en trait plein la puissance optique P telle que définie précédemment.

On remarque sur la figure 4, que la zone de raccord introduit des sauts de puissance en partie supérieure et inférieure de la méridienne. Ces sauts de puissance sont cependant situés au-delà du champ de vision naturel du porteur.

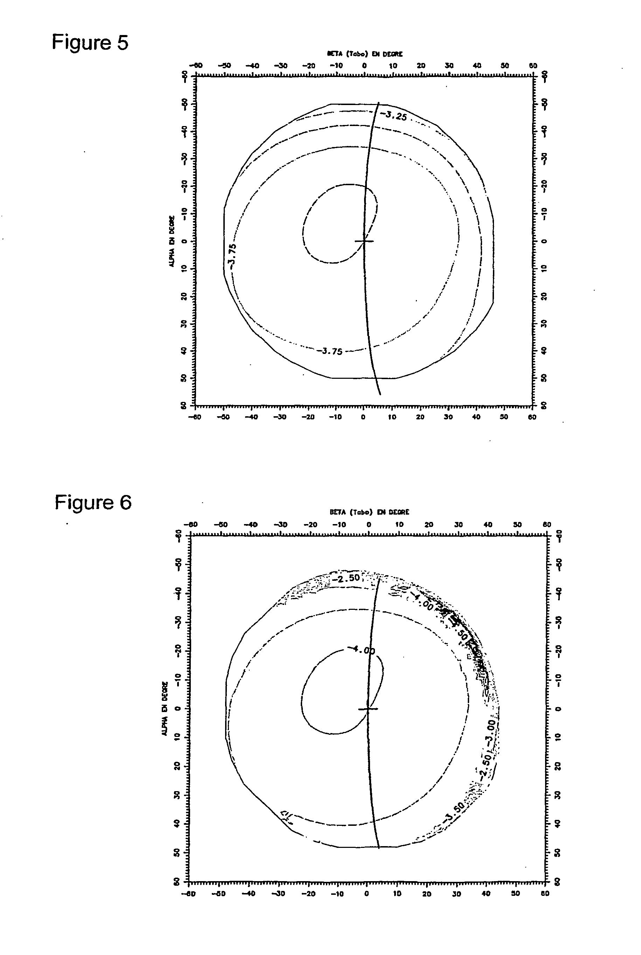

Sur les figures 5 à 8, on a représenté la lentille dans un repère en coordonnées sphériques, l'angle bêta étant porté en abscisse et l'angle alpha en ordonnée.

Les figures 5 et 6 montrent les lignes de niveau de la puissance optique porteur définie en une direction du regard et pour un point objet respectivement pour la lentille cambrée et galbée unifocale classique et pour la lentille cambrée et galbée unifocale selon l'invention. Comme cela est habituel, on a porté sur les figures 5 et 6, dans un repère en coordonnées sphériques, les lignes d'isopuissance; ces lignes sont formées des points présentant une même valeur de la puissance optique P. On constate sur la figure 6 que la zone optiquement utile répondant à la prescription de puissance de -4 dioptries est sensiblement identique à la zone de la figure 5.

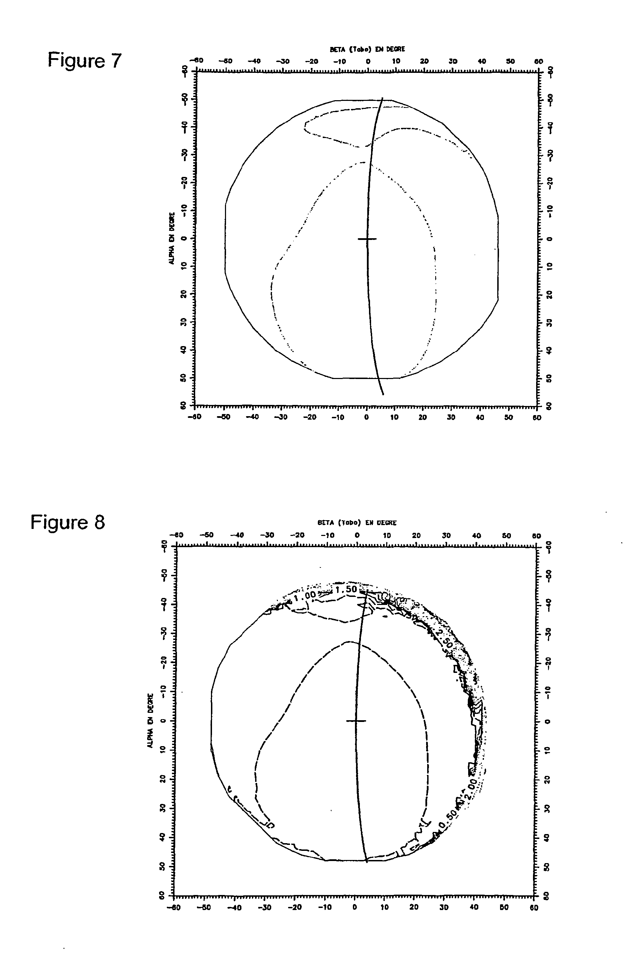

Les figures 7 et 8 montrent les lignes de niveau de l'amplitude de l'astigmatisme oblique au porté ; c'est-à-dire le module de l'astigmatisme résultant, respectivement pour la lentille cambrée et galbée unifocale classique et pour la lentille cambrée et galbée unifocale selon l'invention. Comme cela est habituel, on a porté sur les figures 7 et 8, dans un repère en coordonnées sphériques, les lignes d'iso astigmatisme; ces lignes sont formées des points présentant une même valeur de l'amplitude d'astigmatisme telle que définie précédemment. On constate sur la figure 8 que la lentille de l'invention présente une zone centrale sans défaut d'astigmatisme sensiblement de même taille que la zone de la figure 7.

On constate aussi que les défauts de puissance et d'astigmatisme sont accentués sur le pourtour de la lentille selon l'invention (figures 6 et 8), c'est-à-dire dans la zone périphérique, par rapport à la lentille classique (figures 5 et 7). La transition entre la zone centrale et la zone périphérique de la lentille selon l'invention est cependant continue et régulière et ne détériore pas les qualités optiques de la zone centrale.

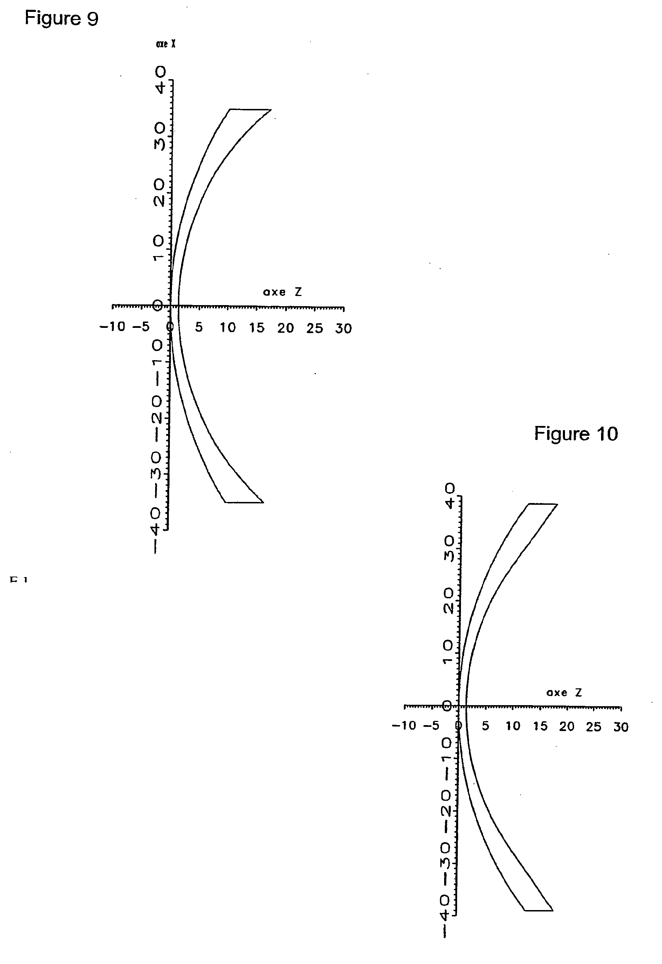

Les figures 9 et 10 montrent des vues schématiques en coupe des lentilles respectivement pour la lentille cambrée et galbée unifocale classique et pour la lentille cambrée et galbée unifocale selon l'invention. La lentille classique (figure 9) présente une épaisseur centre de 1,4 mm et une épaisseur bord comprise entre 8 mm et 9,2 mm. En revanche, la lentille selon l'invention (figure 10) présente une épaisseur centre de 1,4 mm pour une épaisseur bord comprise entre 5 mm et 5,8 mm. Une lentille ainsi amincie est beaucoup plus légère au porté et plus facile à intégrer dans une monture.

L'invention permet donc de réduire considérablement l'épaisseur d'une lentille présentant une cambrure importante, par exemple supérieur à 6 dioptries, pour insertion dans une monture galbée par exemple, sans détériorer les caractéristiques optiques de la lentille pour une même prescription.

Selon un deuxième exemple de réalisation, les figures 11 à 18 montrent une lentille multifocale progressive de prescription +4 dioptries en vision de loin et d'addition 2,5 dioptries avec une face avant sphérique de base 8. La lentille présente un prisme de 1,44° de base géométrique orienté à 270° dans le repère TABO. Le plan du verre est incliné par rapport à la verticale de 8° et présente un galbe de 15° pour un diamètre de 78 mm. Le verre présente un

9

indice de 1,665. On a considéré une valeur de q' de 27 mm (telle que définie en référence à la figure 43) pour les mesures sur la lentille des figures 11 à 16.

Les figures 11, 13, 15 et 17 se rapportent à une lentille classique ayant les caractéristiques indiquées ci-dessus avec une face arrière dégressive asphérisée. Les figures 12, 14, 16 et 18 se rapportent à une lentille selon l'invention ayant les caractéristiques indiquées ci-dessus avec une face arrière dégressive asphérisée et raccordée.

Les figures montrent que la méridienne est sensiblement confondue avec l'axe vertical en partie supérieure de la lentille et présente une inclinaison du côté nasal dans la partie inférieure de la lentille, la convergence étant plus marquée en vision de près. Les figures montrent aussi les repères sur la lentille, en particulier la croix de montage CM, le point de référence en vision de loin VL - situé sur la méridienne et correspondant à une élévation de regard de 8° au dessus de la croix de montage - et le point de référence en vision de près VP - situé sur la méridienne et correspond à un abaissement du regard de 35° en dessous de la croix de montage.

Les figures 11 et 12 montrent la puissance optique porteur le long de la méridienne respectivement pour la lentille cambrée et galbée multifocale classique et pour la lentille cambrée et galbée multifocale selon l'invention ; on a porté en ordonnées l'angle $\beta$ et en abscisses la puissance en dioptries. La zone de vision intermédiaire commence généralement, pour une lentille multifocale progressive, au niveau de la croix de montage CM

On peut noter sur les figures une puissance optique porteur sensiblement constante autour du point de référence en vision de loin VL, une puissance optique porteur sensiblement constante autour du point de référence en vision de près VP et une progression régulière de la puissance le long de la méridienne. Les valeurs sont décalées à zéro à l'origine, où la puissance optique vaut en réalité 4 dioptries correspondant à prescription du porteur en vision de loin. On remarque aussi sur la figure 12, que la zone de raccord introduit des sauts de puissance en partie supérieure et inférieure de la méridienne, bien au delà des points de référence VP et VL, donc bien en dehors du champ de vision du porteur.

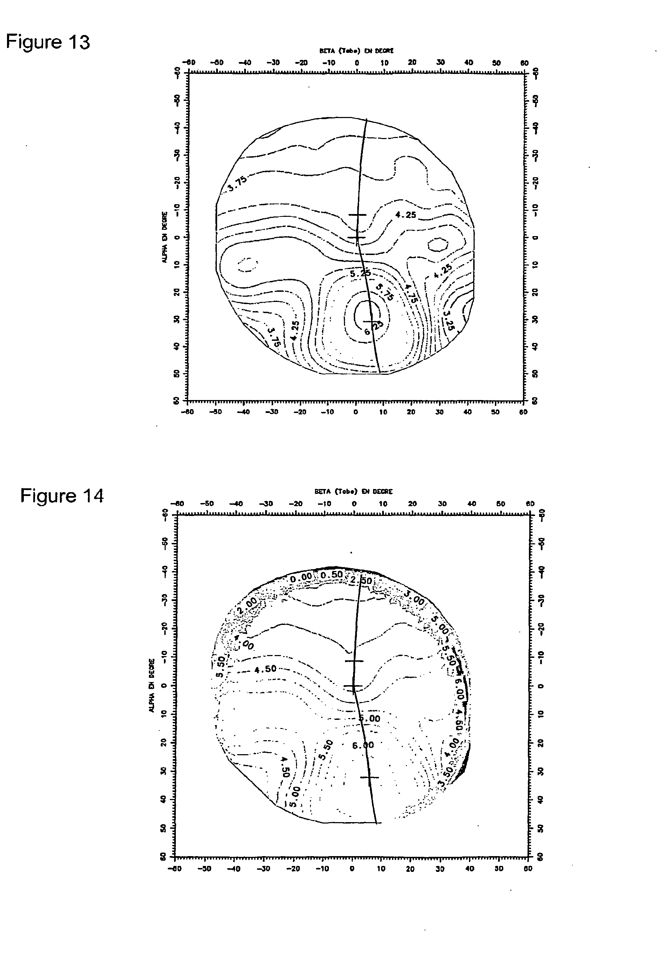

Sur les figures 13 à 16, on a représenté la lentille dans un repère en coordonnées sphériques, l'angle bêta étant porté en abscisse et l'angle alpha en ordonnée.

Les figures 13 et 14 montrent les lignes de niveau de la puissance optique porteur définie en une direction du regard et pour un point objet respectivement pour la lentille cambrée et galbée multifocale classique et pour la lentille cambrée et galbée multifocale selon l'invention. En comparant les figures 13 et 14, on remarque que la lentille selon l'invention présente sensiblement la même répartition du défaut de puissance que la lentille classique pour une même prescription.

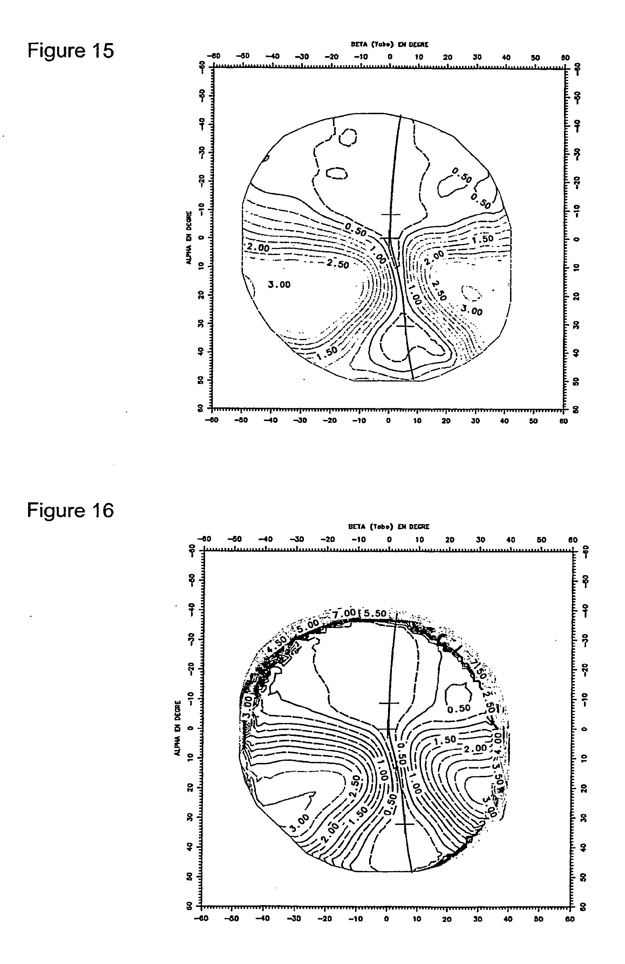

Les figures 15 et 16 montrent les lignes de niveau de l'amplitude de l'astigmatisme oblique au porté ; c'est-à-dire le module de l'astigmatisme résultant, respectivement pour la lentille cambrée et galbée multifocale classique et pour la lentille cambrée et galbée multifocale selon l'invention. On constate que la zone de vision de loin est relativement dégagée pour libérer le champ de vision de loin et que les lignes d'isoastigmatisme s'élargissent, dans la partie inférieure de la lentille, à la hauteur du point de référence pour la vision de près VP pour délimiter un couloir de vision de près VP. En comparant les figures 15 et 16, on remarque que la lentille selon l'invention présente sensiblement la même répartition du défaut d'astigmatisme que la lentille classique pour une même prescription, le couloir en vision de près étant néanmoins plus large autour du point de référence VP sur la lentille de l'invention par rapport à la lentille classique.

On constate aussi, comme pour les figures 5 à 8, que les défauts de puissance et d'astigmatisme sont accentués sur le pourtour de la lentille selon l'invention (figures 14 et 16), c'est-à-dire dans la zone périphérique, par rapport à la lentille classique (figures 13 et 15). La transition entre la zone centrale et la zone périphérique de la lentille selon l'invention est cependant continue et régulière et ne détériore pas les qualités optiques de la zone centrale.

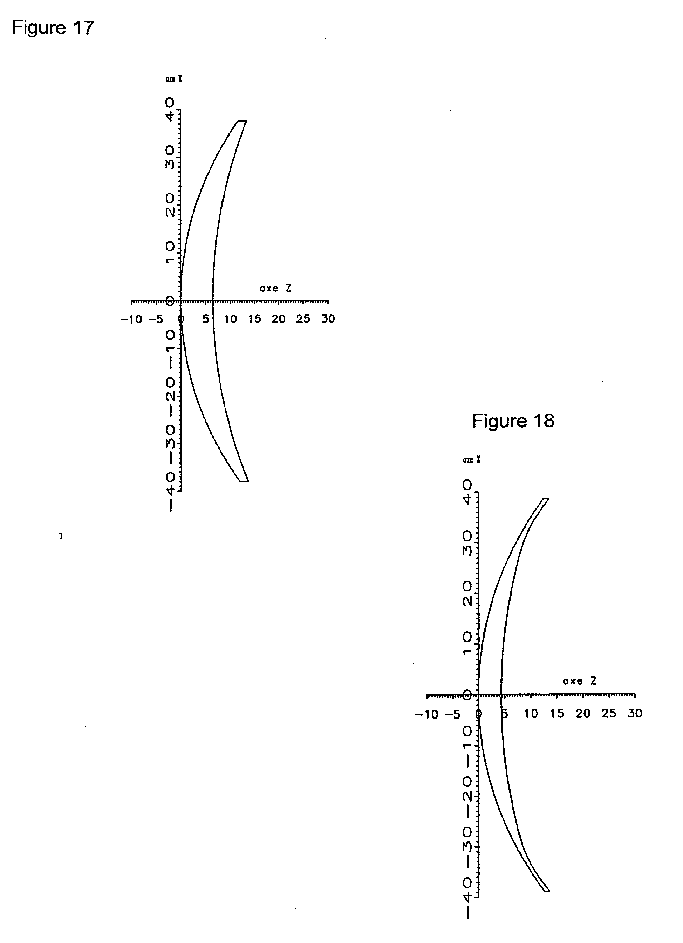

Les figures 17 et 18 montrent des vues schématiques en coupe des lentilles respectivement pour la lentille cambrée et galbée multifocale classique et pour la lentille cambrée et galbée multifocale selon l'invention. La lentille classique (figure 17) présente une épaisseur centre de 6,41 mm et une épaisseur bord comprise entre 0,5 mm et 2,1 mm. En revanche, la lentille selon l'invention (figure 18) présente une épaisseur centre de 4,4 mm pour une épaisseur bord comprise entre 0,5 mm et 1,2 mm. Une lentille ainsi amincie est beaucoup plus légère au porté et plus facile à intégrer dans une monture.

L'invention permet donc de réduire considérablement l'épaisseur d'une lentille multifocale de prescription positive et présentant une cambrure importante, par exemple supérieure à 6 dioptries, pour insertion dans une monture galbée par exemple, sans détériorer les caractéristiques optiques de la lentille pour une même prescription.

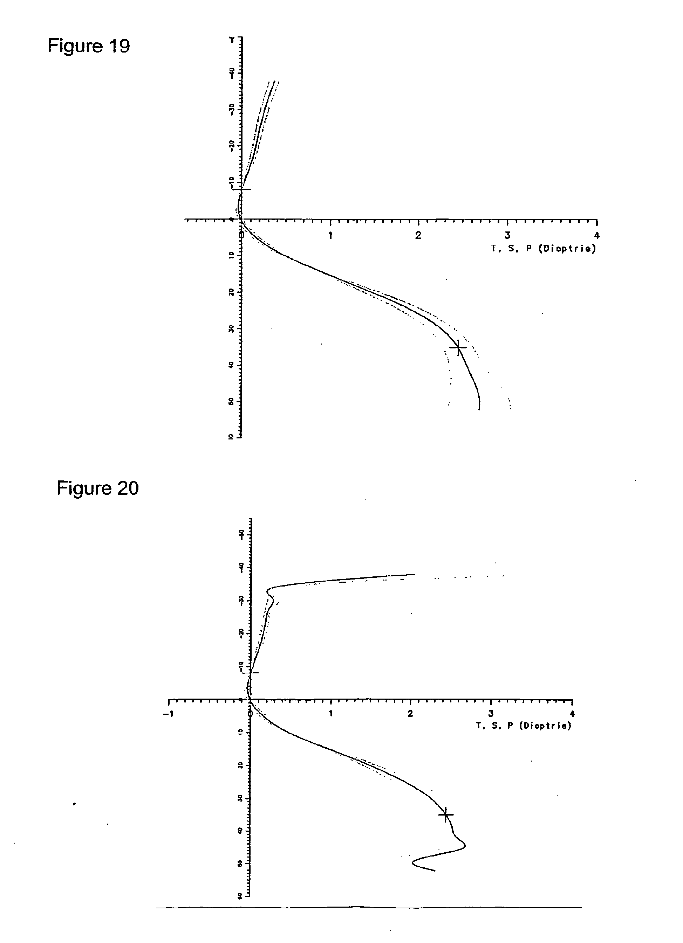

Selon un troisième exemple de réalisation, les figures 19 à 26 montrent une lentille multifocale progressive de prescription -4 dioptries en vision de loin et d'addition 2,5 dioptries avec une face avant sphérique de base 8. La lentille présente un prisme de 1,19° de base géométrique orienté à 282,4° dans le repère TABO. Le plan du verre est incliné par rapport à la verticale de 8° et présente un galbe de 15° pour un diamètre de 70 mm. Le verre présente un indice de 1,665. On a considéré une valeur de q' de 27 mm (telle que définie en référence à la figure 43) pour les mesures sur la lentille des figure 19 à 26.

Les figures 19, 21, 23 et 25 se rapportent à une lentille classique ayant les caractéristiques indiquées ci-dessus avec une face arrière dégressive asphérisée. Les figures 20, 22, 24 et 26 se rapportent à une lentille selon l'invention ayant les caractéristiques indiquées ci-dessus avec une face arrière asphérisée et raccordée et présentant une zone centrale et une zone périphérique dégressives.

Comme sur les figures 11 à 16, la croix de montage CM, le point de référence en vision de loin VL et le point de référence en vision de près VP ont été reportés sur lés figures 19 à 24.

Les figures 19 et 20 montrent la puissance optique porteur le long de la méridienne respectivement pour la lentille multifocale classique et pour la lentille multifocale selon l'invention ; on a porté en ordonnées l'angle $\beta$ et en abscisses la puissance en dioptries. Les valeurs sont décalées à zéro à l'origine, où la puissance optique vaut en réalité -4 dioptries correspondant à prescription du porteur en vision de loin. On remarque aussi sur la figure 20, que la zone de raccord introduit des sauts de puissance en partie supérieure et inférieure de la méridienne, bien au delà des points de référence VP et VL, donc bien en dehors du champ de vision du porteur.

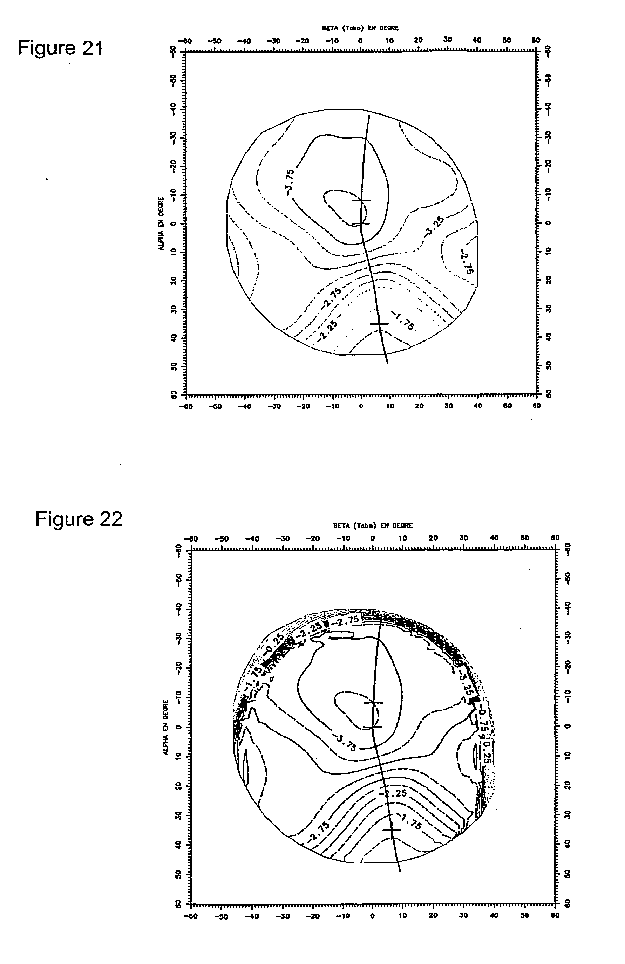

Sur les figures 21 à 24, on a représenté la lentille dans un repère en coordonnées sphériques, l'angle bêta étant porté en abscisse et l'angle alpha en ordonnée.

Les figures 21 et 22 montrent les lignes de niveau de la puissance optique porteur définie en une direction du regard et pour un point objet respectivement pour la lentille cambrée et galbée multifocale classique et pour la lentille cambrée et galbée multifocale selon l'invention. En comparant les figures 21 et 22, on remarque que la lentille selon l'invention présente sensiblement la même répartition du défaut de puissance que la lentille classique pour une même prescription.

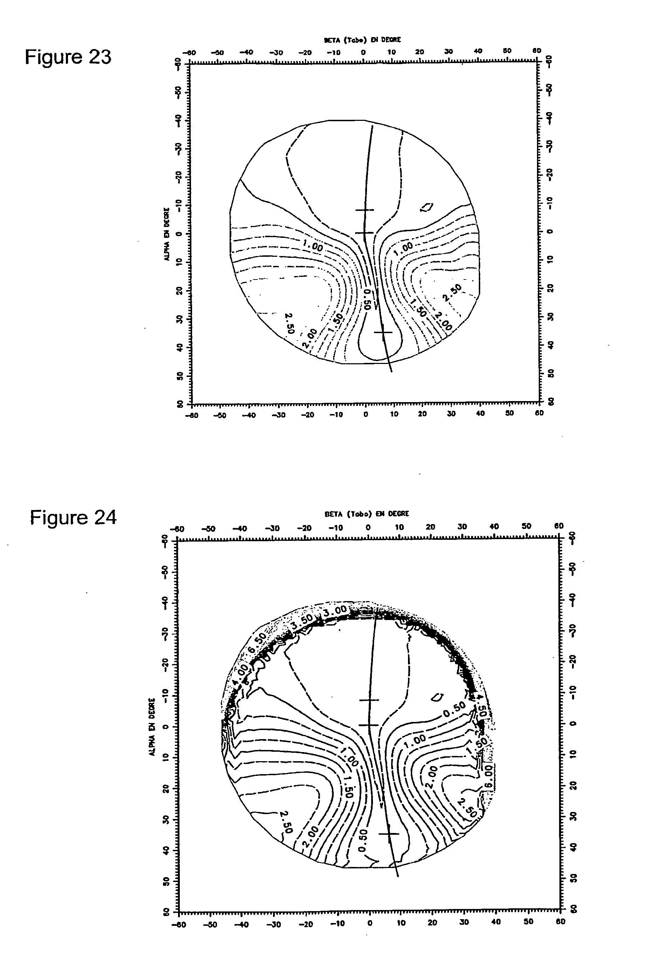

Les figures 23 et 24 montrent les lignes de niveau de l'amplitude de l'astigmatisme oblique au porté ; c'est-à-dire le module de l'astigmatisme résultant, respectivement pour la lentille cambrée et galbée multifocale classique et pour la lentille cambrée et galbée multifocale selon l'invention. En comparant les figures 23 et 24, on remarque que la lentille selon l'invention présente sensiblement la même répartition du défaut d'astigmatisme que la lentille classique pour une même prescription.

On constate aussi, comme pour les figures 13 à 16, que les défauts de puissance et d'astigmatisme sont accentués sur le pourtour de la lentille selon l'invention (figures 22 et 24), c'est-à-dire dans la zone périphérique, par rapport à la lentille classique (figures 21 et 23).

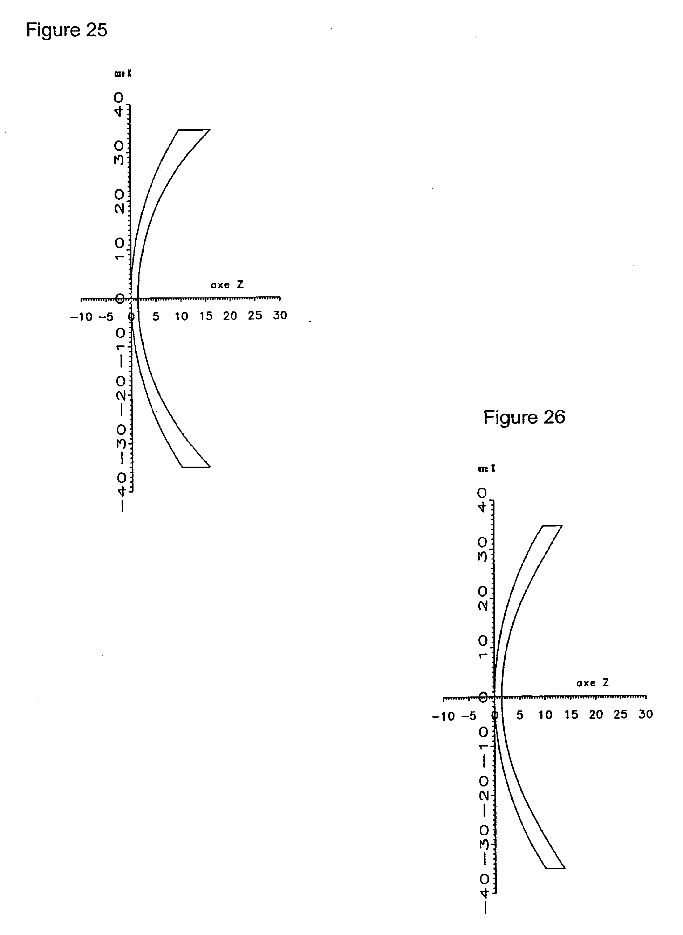

Les figures 25 et 26 montrent des vues schématiques en coupe des lentilles respectivement pour la lentille cambrée et galbée multifocale classique et pour la lentille cambrée et galbée multifocale selon l'invention. La lentille classique (figure 25) présente une épaisseur centre de 1,40 mm et une épaisseur bord comprise entre 5,01 mm et 6,62 mm. En revanche, la lentille selon l'invention (figure 26) présente une épaisseur bord comprise entre 3,52 mm et 4,73 mm pour une épaisseur centre de 1,40 mm. Une lentille ainsi amincie est beaucoup plus légère au porté et plus facile à intégrer dans une monture.

L'invention permet donc de réduire considérablement l'épaisseur d'une lentille multifocale de prescription négative et présentant une cambrure importante, par exemple supérieure à 6 dioptries, pour insertion dans une monture galbée par exemple, sans détériorer les caractéristiques optiques de la lentille pour une même prescription.

Selon un quatrième exemple de réalisation, les figures 27 à 34 montrent une lentille multifocale progressive de prescription -6 dioptries en vision de loin et d'addition 2,5 dioptries avec une face avant complexe de base 2. La lentille présente un prisme de 1,52° de base géométrique orienté à 270° dans le repère TABO. Le plan du verre est incliné par rapport à la verticale de 8° et présente un galbe nul pour un diamètre de 65 mm. Le verre présente un indice de 1,502. On a considéré une valeur de q' de 27 mm (telle que définie en référence à la figure 43) pour les mesures sur la lentille des figure 27 à 34.

Les figures 27, 29, 31 et 33 se rapportent à une lentille classique ayant les caractéristiques indiquées ci-dessus avec une face avant progressive et une face arrière sphérique. Les figures 28, 30, 32 et 34 se rapportent à une lentille selon l'invention ayant les caractéristiques indiquées ci-dessus avec une face avant progressive et une face arrière raccordée. Comme sur les figures 11 à 16, la croix de montage CM, le point de référence en vision de loin VL et le point de référence en vision de près VP ont été reportés sur les figures 27 à 32.

Les figures 27 et 28 montrent la puissance optique porteur le long de la méridienne respectivement pour la lentille multifocale classique, et pour la lentille multifocale selon l'invention ; on a porté en ordonnées l'angle $\beta$ et en abscisses la puissance en dioptries.

On remarque aussi sur la figure 28, que la zone de raccord introduit des sauts de puissance en partie supérieure et inférieure de la méridienne, bien au delà des points de référence VP et VL, donc bien en dehors du champ de vision du porteur.

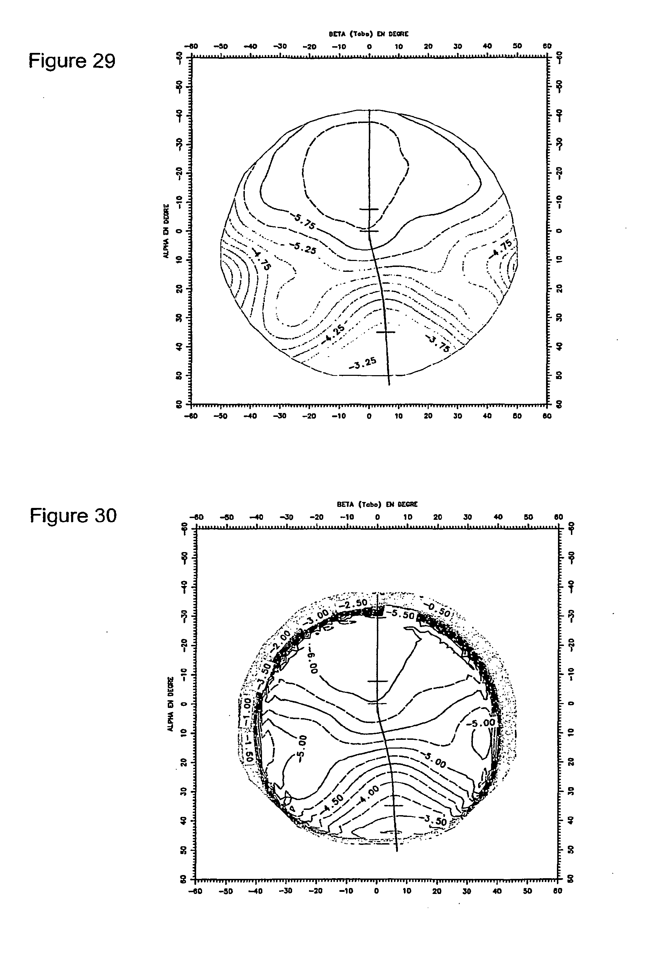

Sur les figures 29 à 32, on a représenté la lentille dans un repère en coordonnées sphériques, l'angle bêta étant porté en abscisse et l'angle alpha en ordonnée.

Les figures 29 et 30 montrent les lignes de niveau de la puissance optique porteur définie en une direction du regard et pour un point objet respectivement pour la lentille multifocale classique et pour la lentille multifocale selon l'invention. En comparant les figures 29 et 30, on remarque que la lentille selon l'invention présente sensiblement la même répartition du défaut de puissance que la lentille classique pour une même prescription.

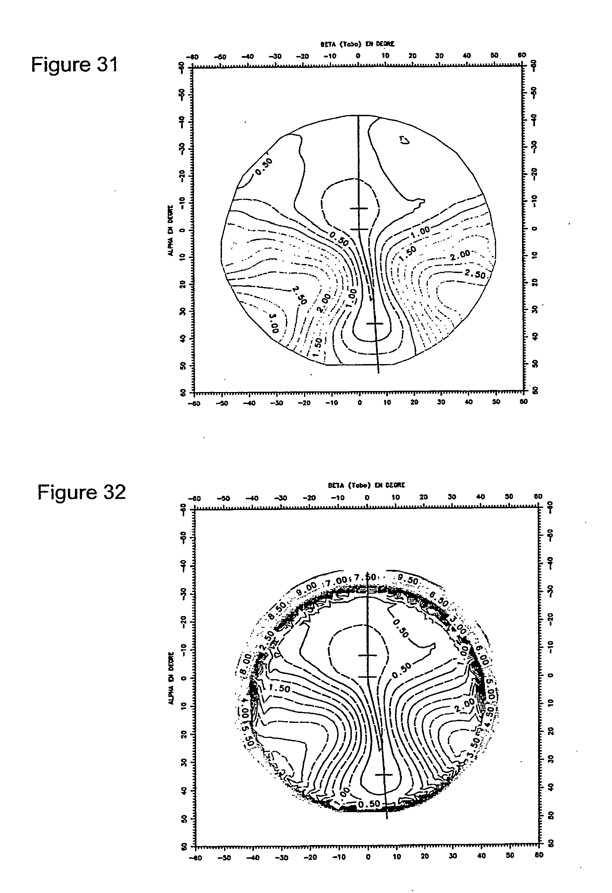

Les figures 31 et 32 montrent les lignes de niveau de l'amplitude de l'astigmatisme oblique au porté ; c'est-à-dire le module de l'astigmatisme résultant, respectivement pour la lentille multifocale classique et pour la lentille multifocale selon l'invention. En comparant les figures 31 et 32, on remarque que la lentille selon l'invention présente sensiblement la même répartition du défaut d'astigmatisme que la lentille classique pour une même prescription.

On constate aussi, comme pour les figures des modes de réalisation précédents, que les défauts de puissance et d'astigmatisme sont accentués sur le pourtour de la lentille selon l'invention (figures 30 et 32), c'est-à-dire dans la zone périphérique, par rapport à la lentille classique (figures 29 et 31). La transition entre la zone centrale et la zone périphérique de la lentille selon l'invention est cependant continue et régulière et ne détériore pas les qualités optiques de la zone centrale.

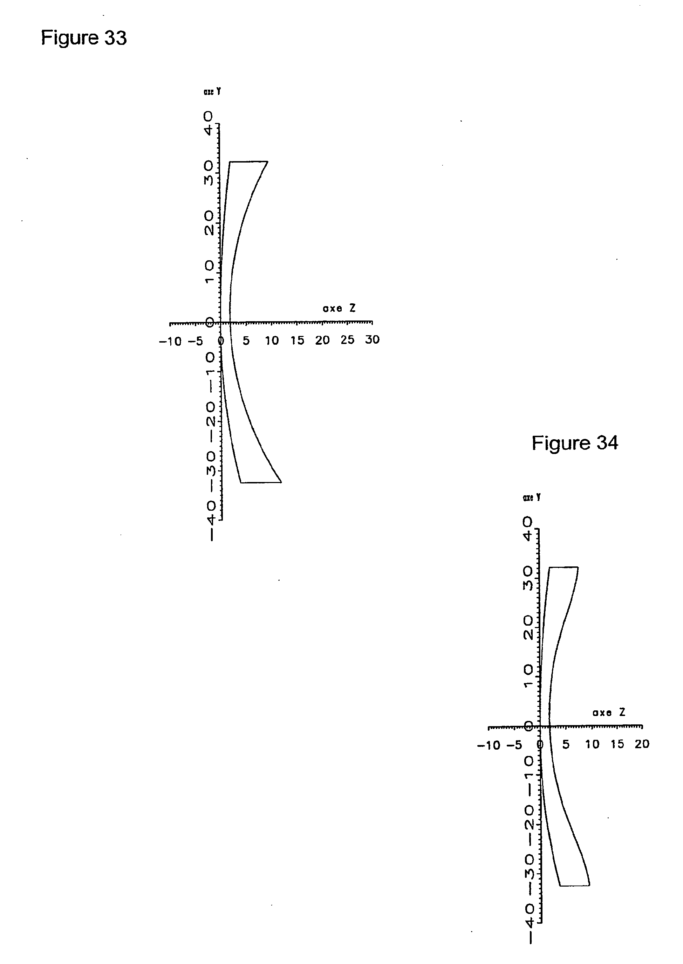

Les figures 33 et 34 montrent des vues schématiques en coupe des lentilles respectivement pour la lentille multifocale classique et pour la lentille multifocale selon l'invention. La lentille classique (figure 33) présente une épaisseur centre de 1,8 mm et une épaisseur bord comprise entre 7,7 mm et 8,4 mm. En revanche, la lentille selon l'invention (figure 34) présente une épaisseur centre de 1,8 mm pour une épaisseur bord comprise entre 5,5 mm et 6,2 mm. Une lentille ainsi amincie est beaucoup plus légère au porté et plus facile à intégrer dans une monture.

L'invention permet donc de réduire considérablement l'épaisseur d'une lentille multifocale présentant une forte prescription de puissance négative, par exemple supérieure à -4 dioptries, sans détériorer les caractéristiques optiques de la lentille pour une même prescription.

Selon un cinquième exemple de réalisation, les figures 35 à 42 montrent une lentille multifocale progressive de prescription +3 dioptries en vision de loin et d'addition 2 dioptries avec une face avant complexe de base 6,5. La lentille présente un prisme de 1,52° de base géométrique orienté à 270° dans le repère TABO. Le plan du verre est incliné par rapport à la verticale de 8° et présente un galbe nul pour un diamètre de 65 mm. Le verre présente un indice de 1,502. On a considéré une valeur de q' de 27 mm (telle que définie en référence à la figure 43) pour les mesures sur la lentille des figure 35 à 42.

Les figures 35, 37, 39 et 41 se rapportent à une lentille classique ayant les caractéristiques indiquées ci-dessus avec une face avant progressive et une face arrière sphérique. Les figures 36, 38, 40 et 42 se rapportent à une lentille selon l'invention ayant les caractéristiques indiquées ci-dessus avec une face avant progressive raccordée. Comme sur les figures 11 à 16, la croix de montage CM, le point de référence en vision de loin VL et le point de référence en vision de près VP ont été reportés sur les figures 35 à 40.

Les figures 35 et 36 montrent la puissance optique porteur le long de la méridienne respectivement pour la lentille multifocale classique et pour la lentille multifocale selon l'invention ; on a porté en ordonnées l'angle $\beta$ et en abscisses la puissance en dioptries.

On remarque sur les figures 35 et 36 que la puissance optique porteur autour des points de référence VL et VP est sensiblement constante. On remarque aussi sur la figure 36, que la zone de raccord introduit des sauts de puissance en partie supérieure et inférieure de la méridienne, bien au delà des points de référence VP et VL, donc bien en dehors du champ de vision du porteur.

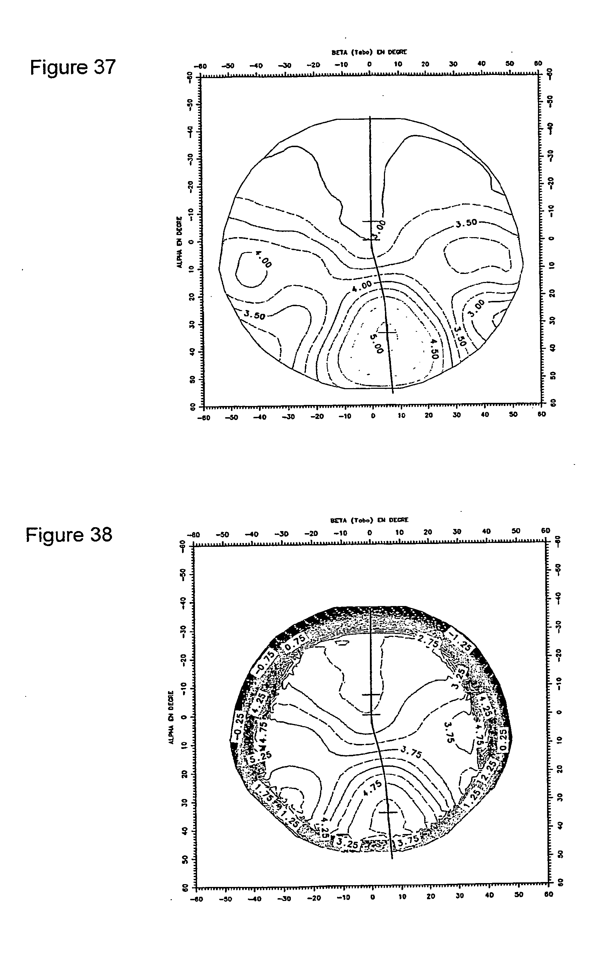

Sur les figures 37 à 40, on a représenté la lentille dans un repère en coordonnées sphériques, l'angle bêta étant porté en abscisse et l'angle alpha en ordonnée.

Les figures 37 et 38 montrent les lignes de niveau de la puissance optique porteur définie en une direction du regard et pour un point objet respectivement pour la lentille multifocale classique et pour la lentille multifocale selon l'invention. En comparant les figures 37 et 38, on remarque que la lentille selon l'invention présente sensiblement la même répartition du défaut de puissance que la lentille classique pour une même prescription.

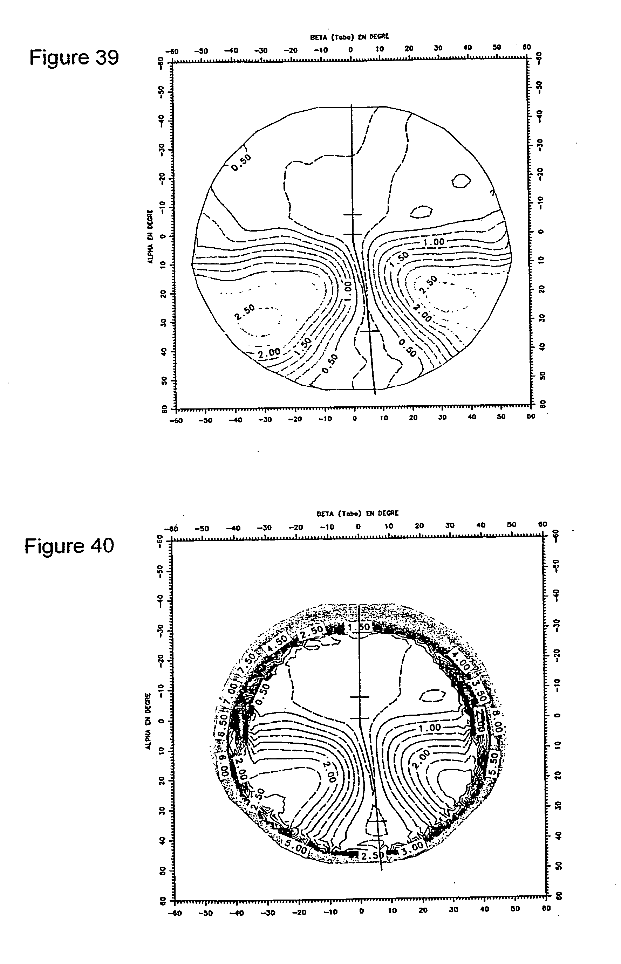

Les figures 39 et 40 montrent les lignes de niveau de l'amplitude de l'astigmatisme oblique au porté ; c'est-à-dire le module de l'astigmatisme résultant, respectivement pour la lentille multifocale classique et pour la lentille multifocale selon l'invention. En comparant les figures 39 et 40, on remarque que la lentille selon l'invention présente sensiblement la même répartition du défaut d'astigmatisme que la lentille classique pour une même prescription.

On constate aussi, comme pour les figures correspondantes des exemples précédents, que les défauts de puissance et d'astigmatisme sont accentués sur le pourtour de la lentille selon l'invention (figures 38 et 40), c'est-à-dire dans la zone périphérique, par rapport à la lentille classique (figures 37 et 39). La transition entre la zone centrale et la zone périphérique de la lentille selon l'invention est cependant continue et régulière et ne détériore pas les qualités optiques de la zone centrale.

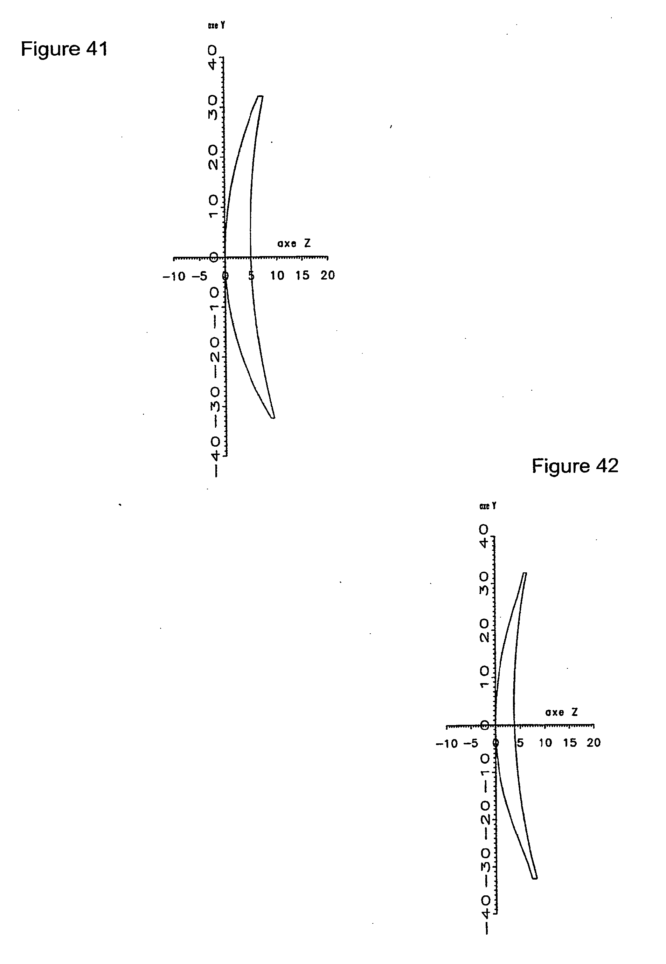

Les figures 41 et 42 montrent des vues schématiques en coupe des lentilles respectivement pour la lentille multifocale classique et pour la lentille multifocale selon l'invention. La lentille classique (figure 41) présente une épaisseur centre de 5,0 mm et une épaisseur bord comprise entre 0,5 mm et 1,4 mm. En revanche, la lentille selon l'invention (figure 42) présente une épaisseur centre de 3,8 mm pour une épaisseur bord comprise entre 0,5 mm et 0,9 mm. Une lentille ainsi amincie est beaucoup plus légère au porté et plus facile à intégrer dans une monture.

L'invention permet donc de réduire considérablement l'épaisseur d'une lentille multifocale présentant une forte prescription de puissance positive, par exemple supérieure à +3 dioptries, sans détériorer les caractéristiques optiques de la lentille pour une même prescription.

Pour procéder à l'optimisation d'une lentille selon l'invention, on considère comme lentille de départ une lentille présentant une première face avec une surface ayant un rayon de courbure maximal.

On définit aussi une zone centrale et une zone périphérique sur la deuxième face de la lentille. Cette zone périphérique a un rayon de courbure maximal compris entre la valeur du rayon de courbure maximal de la première face et la valeur du rayon de courbure maximal de la zone centrale. On choisira la valeur du rayon de courbure maximal de la zone périphérique qui permet d'obtenir un amincissement optimal de la lentille. On peut par exemple imposer des bords de la lentille sensiblement plans. Ainsi, si la première face est sphérique, la zone périphérique de la surface de la deuxième face peut être sphérique et avoir le même rayon de courbure que la première face ; si la première face est torique, la zone périphérique de la surface de la deuxième face peut être torique et avoir la même valeur de plus grand méridien que la première face. Si la surface de la première face est complexe, la zone périphérique de la surface de la deuxième face peut être sphérique ou torique et avoir comme valeur de rayon de courbure ou de plus grand méridien la valeur du rayon de courbure maximal de la première face, ou la zone périphérique de la surface de la deuxième face peut être également complexe et avoir comme valeur de rayon de courbure maximal la valeur du rayon de courbure maximal de la première face ou une valeur comprise entre ce rayon de courbure maximal de la première face et le rayon de courbure maximal de la zone centrale de la deuxième face. En particulier, si la zone centrale présente une variation de puissance, la zone périphérique peut présenter une variation de puissance de même nature (progression ou dégression).

On considère alors la lentille dans les conditions du porté, en fixant les valeurs de distance oeil-lentille q', d'angle pantoscopique (ou inclinaison verticale) et de galbe. On fournit l'épaisseur centre de la lentille et un indice de verre.

On fixe ensuite des cibles pour l'optimisation de la lentille. On définit pour une zone centrale optiquement utile des cibles ayant des valeurs données de puissance, de module d'astigmatisme et d'axe d'astigmatisme pour des directions de regard données.

On détermine alors la lentille par optimisation. A cette fin, on considère une lentille courante; à l'initialisation, cette lentille courante est la lentille de départ. On fait varier les caractéristiques de la deuxième face de la lentille courante pour s'approcher des valeurs cibles de la zone centrale tout en calculant une surface interpolée comprenant une zone de raccord entre les zones centrale et périphérique. La surface interpolée de la deuxième face de la lentille est calculée avec une formule d'interpolation choisie et pour une altitude relative de la zone périphérique par rapport à la zone centrale donnée. On fait varier cette altitude relative de la zone périphérique par rapport à la zone centrale, c'est-à-dire on éloigne ou rapproche selon l'axe Z la zone périphérique de la zone centrale pour obtenir la meilleure surface extrapolée par rapport à une fonction de mérite donnée, par exemple une des fonctions de mérite citées précédemment - minimisation des écarts quadratiques moyens des sphères et cylindres dans les deux directions X et Y ou sur les cercles délimitant les zones centrale et périphérique ; minimisation du cylindre maximal ou des pentes de sphère ou de cylindre dans la zone de raccord.

Pour l'optimisation, on peut utiliser diverses représentations de la ou des surfaces qui varient. Dans l'exemple, on ne fait varier que la face arrière de la lentille, mais on pourrait aussi faire varier la face avant. La ou les faces qui varient peuvent être représentées par des polynômes de Zernike; on peut utiliser une nappe asphérique, superposée à l'une ou l'autre des faces, et faire varier cette nappe asphérique. L'optimisation peut utiliser les techniques connues en soi. En particulier, on pourra utiliser la méthode d'optimisation par moindres carrés amortis (DLS).

L'invention permet ainsi d'obtenir une lentille cambrée et/ou de forte prescription d'épaisseur réduite sans accentuer les défauts d'obliquité pour un bon confort visuel du porteur.

**Revendications**

1. Procédé de détermination d'une lentille ophtalmique comprenant les étapes de:

   - choix d'une lentille de départ avec une première face et une deuxième face ;
   - définition d'une surface de départ pour la deuxième face de la lentille avec une zone centrale (15) de diamètre $D_{ini}$ et une zone périphérique (17) de diamètre intérieur $D_{rac}$ supérieur au diamètre $D_{ini}$ de la zone centrale,

   chaque point de la zone centrale (15) et de la zone périphérique (17) présentant une altitude définie par rapport à un axe (Z) normal à la deuxième face de la lentille et ayant pour origine le centre de la zone centrale (15), l'altitude de la zone périphérique (17) étant définie comme l'altitude du point le plus bas situé sur le diamètre intérieur $D_{rac}$ ; la zone périphérique (17) ayant un rayon de courbure maximal compris entre le rayon de courbure maximal de la première face et le rayon de courbure maximal de la zone centrale (15) ;

   - choix d'une formule d'interpolation ;
   - définition d'une lentille courante égale à la lentille de départ ;
   - optimisation de la lentille courante en appliquant :

- des valeurs cibles de puissance et d'astigmatisme pour des directions de regard données dans la zone centrale (15) de la deuxième face de la lentille ;
- la formule d'interpolation aux zones centrale (15) et périphérique (17) pour définir une surface interpolée comprenant une zone de raccord (16), la surface interpolée minimisant une fonction de mérite (FM) pour différentes altitudes relatives de la zone périphérique (17) par rapport à la zone centrale (15).

2. Le procédé de détermination d'une lentille ophtalmique de la revendication 1, dans lequel l'optimisation de la zone centrale (15) de la lentille courante est réalisée dans les conditions du porté.

3. Le procédé de détermination d'une lentille ophtalmique de la revendication 1 ou 2, dans lequel la fonction de mérite (FM) est une minimisation des écarts quadratiques moyens en sphères et en cylindres calculés sur un ensemble de points entre la surface interpolée et les surfaces initiales des zones centrale et périphérique.

4. Le procédé de détermination d'une lentille ophtalmique de la revendication 3, dans lequel l'ensemble de points pour lesquels une minimisation des écarts quadratiques moyens en sphères et en cylindres sont calculés consiste dans les axes verticaux et horizontaux de la lentille.

5. Le procédé de détermination d'une lentille ophtalmique de la revendication 3, dans lequel l'ensemble de points pour lesquels une minimisation des écarts quadratiques moyens en sphères et en cylindres sont calculés consiste dans les cercles de diamètre $D_{ini}$ et $D_{rac}$ délimitant respectivement les zones centrale et périphérique.

6. Le procédé de détermination d'une lentille ophtalmique de la revendication 1 ou 2, dans lequel la fonction de mérite (FM) est une minimisation de la valeur du cylindre maximal dans la zone de raccord (16).

7. Le procédé de détermination d'une lentille ophtalmique de la revendication 1 ou 2, dans lequel la fonction de mérite (FM) est une minimisation de la norme du gradient de sphère ou de cylindre dans la zone de raccord (16).

8. Le procédé de détermination d'une lentille ophtalmique de l'une des revendications 1 à 7, dans lequel les zones centrale, de raccord et périphérique sont centrées sur un même point de la surface de la deuxième face de la lentille, ledit point de centrage matérialisant la direction primaire du regard dans les conditions du porté.

9. Le procédé de détermination d'une lentille ophtalmique de la revendication 4, dans lequel la fonction de mérite (FM) de la minimisation des écarts quadratiques moyens en sphères et en cylindres verticaux et horizontaux entre la surface interpolée et les surfaces des zones centrale et périphérique est définie comme :

$$FM = a\,FM\_X + b\,FM\_Y\ ;$$

Avec a et b des coefficients de pondération ; et avec

$$FM\_X = \sqrt{\frac{\sum_{i=1}^{n}\left(Sph\_xi - Sph'\_xi\right)^2}{n}} + \sqrt{\frac{\sum_{i=1}^{n}\left(Cyl\_xi - Cyl'\_xi\right)^2}{n}}$$

$$FM\_Y = \sqrt{\frac{\sum_{i=1}^{n}\left(Sph\_yi - Sph'\_yi\right)^2}{n}} + \sqrt{\frac{\sum_{i=1}^{n}\left(Cyl\_yi - Cyl'\_yi\right)^2}{n}}$$

Où *Sph_xi* et *Shp_yi* sont les valeurs de sphères initiales en un point considéré dans la zone centrale ou dans la zone périphérique sur l'axe X et sur l'axe Y ;

Où *Cyl_xi* et *Cyl_yi* sont les valeurs de cylindres initiales en un point considéré dans la zone centrale ou dans la zone périphérique sur l'axe X et sur l'axe Y ; et

Où *Sph'_xi, Shp'_yi* et *Cyl'_xi, Cyl'_yi* sont les valeurs de sphères et de cylindres en un point considéré de la surface interpolée dans la zone de raccord sur l'axe X et sur l'axe Y.

**10.** Le procédé de détermination d'une lentille ophtalmique de l'une des revendications 1 à 9, dans lequel la première face de la lentille est choisie complexe.

**11.** Le procédé de détermination d'une lentille ophtalmique de l'une des revendications 1 à 9, dans lequel la première face et la zone périphérique de la deuxième face de la lentille sont choisies sphériques.

**12.** Le procédé de détermination d'une lentille ophtalmique de l'une des revendications 1 à 9, dans lequel la première face et la zone périphérique de la deuxième face de la lentille sont choisies toriques.

**13.** Le procédé de détermination d'une lentille ophtalmique de l'une des revendications 1 à 10, dans lequel la zone centrale de la deuxième face est choisie avec une variation de puissance.

**14.** Le procédé de détermination d'une lentille ophtalmique de l'une des revendications 1 à 10, dans lequel la zone centrale et la zone périphérique de la deuxième face sont choisies avec une variation de puissance.

**15.** Le procédé de détermination d'une lentille ophtalmique de l'une des revendications 1 à 14, dans lequel le diamètre ($D_{ini}$) de la zone centrale (15) est choisi supérieur ou égal à 30 mm et inférieur d'au moins 10 mm au diamètre total ($D_{fin}$) de la lentille avant détourage (30 mm $\leq D_{ini} \leq D_{fin}$ - 10 mm).

**16.** Le procédé de détermination d'une lentille ophtalmique de l'une des revendications 1 à 15, dans lequel le diamètre intérieur ($D_{rac}$) de la zone périphérique (17) est choisi supérieur ou égal d'au moins 10 mm au diamètre de la zone centrale ($D_{ini}$) et inférieur au diamètre total ($D_{fin}$) de la lentille avant détourage.

**Patentansprüche**

**1.** Verfahren zur Bestimmung eines Augenglases, das die folgenden Schritte umfasst:

- Auswahl eines Ausgangsglases mit einer ersten Seite und einer zweiten Seite,
- Definition einer Ausgangsfläche für die zweite Seite des Glases mit einer zentralen Zone (15) mit dem Durchmesser $D_{ini}$ und einer peripheren Zone (17) mit dem Innendurchmesser $D_{rac}$, der größer ist als der Durchmesser $D_{ini}$ der zentralen Zone,

wobei jeder Punkt der zentralen Zone (15) und der peripheren Zone (17) eine Höhe aufweist, die im Verhältnis zu einer zur zweiten Seite des Glases normalen Achse (Z) definiert ist und deren Ursprung das Zentrum der zentralen Zone (15) ist, wobei die Höhe der peripheren Zone (17) als Höhe des niedrigsten Punkts definiert ist, der sich auf dem Innendurchmesser $D_{rac}$ befindet,
wobei die periphere Zone (17) einen maximalen Krümmungsradius zwischen dem maximalen Krümmungsradius der ersten Seite und dem maximalen Krümmungsradius der zentralen Zone (15) inklusive hat,

- Auswahl einer Interpolationsformel,
- Definition eines Standardglases, das dem Ausgangsglas entspricht,
- Optimierung des Standardglases durch Anwendung:

- der Leistungs- und Astigmatismuszielwerte für gegebene Blickrichtungen in der zentralen Zone (15) der zweiten Seite des Glases,
- der Interpolationsformel auf die zentrale (15) und periphere Zone (17), um eine interpolierte Fläche zu definieren, die eine Verbindungszone (16) umfasst, wobei die interpolierte Fläche eine Merit-Funktion (FM) für verschiedene relative Höhen der peripheren Zone (17) im Verhältnis zu der zentralen Zone (15) minimiert.

**2.** Verfahren zur Bestimmung eines Augenglases nach Anspruch 1, wobei die Optimierung der zentralen Zone (15) des Standardglases unter den Tragebedingungen durchgeführt wird.

**3.** Verfahren zur Bestimmung eines Augenglases nach Anspruch 1 oder 2, wobei die Merit-Funktion (FM) eine Minimierung der mittleren quadratischen Abweichungen in Sphären und in Zylindern ist, berechnet für eine Gruppe von Punkten zwischen der interpolierten Fläche und den Ausgangsflächen der zentralen und peripheren Zone.

**4.** Verfahren zur Bestimmung eines Augenglases nach Anspruch 3, wobei die Gruppe von Punkten, für die eine Minimierung der mittleren quadratischen Abweichungen in Sphären und in Zylindern berechnet wird, aus den vertikalen und horizontalen Achsen des Glases besteht.

**5.** Verfahren zur Bestimmung eines Augenglases nach Anspruch 3, wobei die Gruppe von Punkten, für die eine Minimierung der mittleren quadratischen Abweichungen in Sphären und in Zylindern berechnet wird, aus Kreisen mit dem Durchmesser $D_{ini}$ und $D_{rac}$ besteht, die jeweils die zentrale und periphere Zone begrenzen.

**6.** Verfahren zur Bestimmung eines Augenglases nach Anspruch 1 oder 2, wobei die Merit-Funktion (FM) eine Minimierung des Wertes des maximalen Zylinders in der Verbindungszone (16) ist.

**7.** Verfahren zur Bestimmung eines Augenglases nach Anspruch 1 oder 2, wobei die Merit-Funktion (FM) eine Minimierung der Norm des Sphären- oder Zylindergradienten in der Verbindungszone (16) ist.

**8.** Verfahren zur Bestimmung eines Augenglases nach einem der Ansprüche 1 bis 7, wobei die zentrale, Verbindungs- und periphere Zone auf einen selben Punkt der Fläche der zweiten Seite des Glases zentriert sind, wobei der Zentrierpunkt die primäre Richtung des Blicks unter Tragebedingungen materialisiert.

**9.** Verfahren zur Bestimmung eines Augenglases nach Anspruch 4, wobei die Merit-Funktion (FM) der Minimierung der mittleren quadratischen Abweichungen in Sphären und in vertikalen und horizontalen Zylindern zwischen der interpolierten Fläche und den Flächen der zentralen und peripheren Zone wie folgt definiert ist:

$$FM = a\,FM\_X + b\,FM\_Y,$$

wobei a und b Wichtungskoeffizienten sind, und mit

$$FM\_X = \sqrt{\frac{\sum_{i=1}^{n}\left(Sph\_xi - Sph'\_xi\right)^2}{n}} + \sqrt{\frac{\sum_{i=1}^{n}\left(Cyl\_xi - Cyl'\_xi\right)^2}{n}}$$

$$FM\_Y = \sqrt{\frac{\sum_{i=1}^{n}\left(Sph\_yi - Sph'\_yi\right)^2}{n}} + \sqrt{\frac{\sum_{i=1}^{n}\left(Cyl\_yi - Cyl'\_yi\right)^2}{n}}$$

wobei *Sph_xi* und *Shp_yi* Ausgangsphärenwerte in einem betrachteten Punkt in der zentralen Zone oder in der peripheren Zone auf der Achse X und auf der Achse Y sind,
wobei *Cyl_xi* und *Cyl_yi* die Ausgangszylinderwerte in einem betrachteten Punkt in der zentralen Zone oder in der peripheren Zone auf der Achse X und auf der Achse Y sind, und
wobei *Sph_xi, Shp_yi* und *Cyl_xi, Cyl_yi* die Sphären- und Zylinderwerte in einem betrachteten Punkt der interpolierten Fläche in der Verbindungszone auf der Achse X und auf der Achse Y sind.

**10.** Verfahren zur Bestimmung eines Augenglases nach einem der Ansprüche 1 bis 9, wobei die erste Seite des Glases komplex ausgewählt ist.

**11.** Verfahren zur Bestimmung eines Augenglases nach einem der Ansprüche 1 bis 9, wobei die erste Seite und die periphere Zone der zweiten Seite des Glases sphärisch ausgewählt sind.

**12.** Verfahren zur Bestimmung eines Augenglases nach einem der Ansprüche 1 bis 9, wobei die erste Seite und die periphere Zone der zweiten Seite des Glases torisch ausgewählt sind.

**13.** Verfahren zur Bestimmung eines Augenglases nach einem der Ansprüche 1 bis 10, wobei die zentrale Zone der zweiten Seite mit einer Leistungsvariation ausgewählt ist.

**14.** Verfahren zur Bestimmung eines Augenglases nach einem der Ansprüche 1 bis 10, wobei die zentrale Zone und die periphere Zone der zweiten Seite mit einer Leistungsvariation ausgewählt sind.

**15.** Verfahren zur Bestimmung eines Augenglases nach einem der Ansprüche 1 bis 14, wobei der Durchmesser ($D_{ini}$) der zentralen Zone größer oder gleich 30 mm und mindestens 10 mm kleiner als der Gesamtdurchmesser ($D_{fin}$) des Glases vor dem Umfangsfräsen ausgewählt ist (30 mm $\leq D_{ini} \leq D_{fin}$ - 10 mm).

**16.** Verfahren zur Bestimmung eines Augenglases nach einem der Ansprüche 1 bis 15, wobei der Innendurchmesser ($D_{rac}$) der peripheren Zone (17) gleich oder mindestens 10 mm größer als der Durchmesser der zentralen Zone ($D_{fin}$) und kleiner als der Gesamtdurchmesser ($D_{fin}$) des Glases vor dem Umfangsfräsen ausgewählt ist.

**Claims**

**1.** A method for determining an ophthalmic lens comprising the steps of:

- selecting an initial lens with a first face and a second face;
- defining an initial surface for the second face of the lens with a central area (15) of diameter $D_{ini}$ and a peripheral area (17) of inner diameter $D_{rac}$ greater than the diameter $D_{ini}$ of the central area,

each point of the central area (15) and of the peripheral area (17) having an altitude defined relatively to an axis (Z) normal to the second face of the lens and originating from the center of the central area (15), the altitude of the peripheral area (17) being defined as the altitude of the lowest point located on the inner diameter $D_{rac}$;
the peripheral area (17) having a maximum radius of curvature comprised between the maximum radius of curvature of the first face and the maximum radius of curvature of the central area (15);

- selecting an interpolation formula;
- defining a current lens equal to the initial lens;
- optimizing the current lens by applying:

- power and astigmatism target values for given gaze directions in the central area (15) of the second face of the lens;
- the interpolation formula to the central (15) and peripheral (17) areas in order to define an interpolated surface comprising a connection area (16), the interpolated surface minimizing a merit function (FM) for different relative altitudes of the peripheral area (17) with respect to the central area (15).

**2.** The method for determining an ophthalmic lens according to claim 1, wherein the optimization of the central area (15) of the current lens is achieved under wearing conditions.

**3.** The method for determining an ophthalmic lens according to claim 1 or 2, wherein the merit function (FM) is a minimization of the sphere and cylinder standard deviations calculated over a set of points between the interpolated surface and the initial surfaces of the central and peripheral areas.

**4.** The method for determining an ophthalmic lens according to claim 3, wherein the set of points for which minimizations of the sphere and cylinder standard deviations are calculated, consists in the vertical and horizontal axes of the lens.

**5.** The method for determining an ophthalmic lens according to claim 3, wherein the set of points for which minimizations of the sphere and cylinder standard deviations are calculated, consists in the circles of diameters $D_{ini}$ and $D_{rac}$ respectively delimiting the central and peripheral areas.

**6.** The method for determining an ophthalmic lens according to claim 1 or 2, wherein the merit function (FM) is a minimization of the value of the maximum cylinder in the connection area (16).

**7.** The method for determining an ophthalmic lens according to claim 1 or 2, wherein the merit function (FM) is a minimization of the norm of the sphere or cylinder gradient in the connection area (16).

**8.** The method for determining an ophthalmic lens according to one of claims 1 to 7, wherein the central, connection and peripheral areas are centered on a same point of the surface of the second face of the lens, said centering point materializing the primary gaze direction under the wearing conditions.

**9.** The method for determining an ophthalmic lens according to claim 3, wherein the merit function (FM) of the minimization of the vertical and horizontal sphere and cylinder standard deviations between the interpolated surface and the surfaces of the central and peripheral areas is defined as:

$$FM = a\, FM\_X + b\, FM\_Y;$$

with weighting coefficients a and b; and with

$$FM\_X = \sqrt{\frac{\sum_{i=1}^{n}(Sph\_xi - Sph'\_xi)^2}{n}} + \sqrt{\frac{\sum_{i=1}^{n}(Cyl\_xi - Cyl'\_xi)^2}{n}}$$

$$FM\_Y = \sqrt{\frac{\sum_{i=1}^{n}(Sph\_yi - Sph'\_yi)^2}{n}} + \sqrt{\frac{\sum_{i=1}^{n}(Cyl\_yi - Cyl'\_yi)^2}{n}}$$

wherein *Sph_xi* and *Sph_yi* are the initial values of spheres in a relevant point in the central area or in the peripheral area on the X axis and on the Y axis;
wherein *Cyl_xi* and *Cyl_yi* are the initial values of cylinders in a relevant point in the central area or in the peripheral area on the X axis and on the Y axis; and
wherein *Sph'_xi, Sph'_yi* and *Cyl'_xi, Cyl'_yi* are the values of spheres and cylinders in a relevant point of the interpolated surface in the connecting area on the X axis and on the Y axis.

**10.** The method for determining an ophthalmic lens according to one of claims 1 to 9, wherein the first face of the lens is selected to be complex.

**11.** The method for determining an ophthalmic lens according to one of claims 1 to 9, wherein the first face and the peripheral area of the second face of the lens are selected to be spherical.

**12.** The method for determining an ophthalmic lens according to one of claims 1 to 9, wherein the first face and the peripheral area of the second face of the lens are selected to be toric.

**13.** The method for determining an ophthalmic lens according to one of claims 1 to 10, wherein the central area of the second face is selected with a variation of power.

**14.** The method for determining an ophthalmic lens according to one of claims 1 to 10, wherein the central area and the peripheral area of the second face are selected with a variation of power.

**15.** The method for determining an ophthalmic lens according to one of claims 1 to 14, wherein the diameter ($D_{ini}$) of the central area (15) is selected to be greater than or equal to 30 mm and smaller by at least 10 mm than the total diameter ($D_{fin}$) of the lens before trimming (30 mm $\leq D_{ini} \leq D_{fin}$ - 10 mm).

16. The method for determining an ophthalmic lens according to one of claims 1 to 15, wherein the diameter ($D_{rac}$) of the peripheral area (17) is selected to be at least 10 mm greater than or equal to the diameter of the central area ($D_{ini}$) and smaller than the total diameter ($D_{fin}$) of the lens before trimming.

Figure 1

15

16

10

17

D ini

D rac

D fin

Figure 2

17

15

## Figure 3

T, S, P (Dioptrie)

## Figure 4

T, S, P (Dioptrie)

Figure 5

Figure 6

Figure 7

Figure 8

Figure 9

Figure 10

axe X

axe Z

axe Z

Figure 11

Figure 12

Figure 13

Figure 14

Figure 15

Figure 16

Figure 17

Figure 18

**Figure 19**

**Figure 20**

**Figure 21**

**Figure 22**

Figure 23

Figure 24

**Figure 25**

**Figure 26**

Figure 27

T. S. P (Dioptrie)

Figure 28

T. S. P (Dioptrie)

Figure 29

Figure 30

Figure 31

Figure 32

## Figure 33

## Figure 34

Figure 35

T. S. P (Dioptrie)

Figure 36

T. S. P (Dioptrie)

Figure 37

Figure 38

**Figure 39**

**Figure 40**

Figure 41

Figure 42

Figure 43

Figure 44

Figure 45

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2699294 A
- US 5270745 A
- US 5272495 A
- FR 2683642 A
- FR 2704327 A
- EP 0990939 A
- WO 9812590 A
- US 6698884 A
- US 6454408 A
- US 6334681 A
- US 6364481 A
- WO 9735224 A
- FR 2638246 A
- EP 0371460 A
- US 6176577 A